(19) 

Europäisches
Patentamt
European
Patent Office
Office européen
des brevets

(11) **EP 4 746 323 A1**

(12) **EUROPEAN PATENT APPLICATION**
published in accordance with Art. 153(4) EPC

(43) Date of publication:
**20.05.2026 Bulletin 2026/21**

(21) Application number: **23948800.0**

(22) Date of filing: **14.08.2023**

(51) International Patent Classification (IPC):
*H04L 1/00* (2006.01)      *H03M 13/11* (2006.01)

(52) Cooperative Patent Classification (CPC):
**H03M 13/11; H04L 1/00**

(86) International application number:
**PCT/CN2023/112966**

(87) International publication number:
**WO 2025/035365 (20.02.2025 Gazette 2025/08)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **Huawei Technologies Co., Ltd.**
**Shenzhen, Guangdong 518129 (CN)**

(72) Inventors:
• **LIU, Ke**
**Shenzhen, Guangdong 518129 (CN)**

• **ZHANG, Huazi**
**Shenzhen, Guangdong 518129 (CN)**
• **TONG, Jiajie**
**Shenzhen, Guangdong 518129 (CN)**
• **WANG, Xianbin**
**Shenzhen, Guangdong 518129 (CN)**
• **WANG, Jun**
**Shenzhen, Guangdong 518129 (CN)**

(74) Representative: **Goddar, Heinz J.**
**Boehmert & Boehmert**
**Anwaltspartnerschaft mbB**
**Pettenkoferstrasse 22**
**80336 München (DE)**

(54) **COMMUNICATION METHOD BASED ON LDPC CODE, AND COMMUNICATION APPARATUS**

(57)      An LDPC code-based communication method and a communication apparatus are provided. Through row grouping and column grouping, an LDPC base matrix may be divided into a plurality of units of a same scale. The plurality of units include three types: a first unit, a second unit, and a third unit. A column weight of each column of the first unit is 1. A column weight of at least one column of the second unit is 1, and a column weight of a remaining column is 0. A column weight of each column of the third unit is 0. None of the column weights of the columns of the first unit, the second unit, and the third unit is greater than 1. Therefore, a receiver device may perform parallel decoding of a plurality of QC blocks on a codeword sequence corresponding to each unit, and a case in which decoding cannot be performed does not occur. This helps improve decoding performance.

FIG. 10

EP 4 746 323 A1

**Description**

## TECHNICAL FIELD

This application relates to the coding field, and more specifically, to an LDPC code-based communication method and a communication apparatus.

## BACKGROUND

In the field of channel coding, a low-density parity check (low-density parity check, LDPC) code is one of most mature and widely applied channel coding schemes.

Currently, considering both a chip area and idle resources, a chip is designed based on a codeword that supports using a maximum lifting value for decoding. For example, a lifting value supported by new radio (new radio, NR) ranges from 2 to 384, and the chip is designed based on the maximum lifting value 384. However, in an actual decoding process, a used lifting value may be less than the maximum lifting value. In this case, a manner of parallel decoding of a plurality of quasi-cyclic (quasi-cyclic, QC) blocks may be used. However, an edge relationship of a current LDPC code is highly random, which may cause a failure in the parallel decoding of the plurality of QC blocks, and affect decoding performance.

## SUMMARY

This application provides an LDPC code-based communication method and a communication apparatus, to help improve decoding performance.

According to a first aspect, an LDPC code-based communication method is provided. The method may be performed by a transmitter device, or may be performed by a module or a unit (for example, a chip) in the transmitter device. For ease of description, the following uses the transmitter device for description. The transmitter device may be a terminal device or a network device.

The method includes: obtaining an information bit sequence; performing LDPC encoding on the information bit sequence based on an LDPC base matrix to obtain a first LDPC codeword sequence, where a $(q \times (i-1)+1)^{th}$ row to a $(q \times i)^{th}$ row of a first part of the LDPC base matrix include $M_i$ first units, $F_i$ second units, and $G_i$ third units; the first part is a matrix region including a $1^{st}$ column to an $x^{th}$ column of the LDPC base matrix; the first unit is a matrix with q rows and k columns, and a column weight of each column is 1; the second unit is a matrix with q rows and k columns, a column weight of at least one column of the second unit is 1, and a column weight of a remaining column is 0; the third unit is a matrix with q rows and k columns, and a column weight of each column is 0; i and q are positive integers; x and k are integers greater than or equal to 2; $M_i$ is a positive integer; and $F_i$ and $G_i$ are nonnegative integers; and outputting a second LDPC codeword sequence based on the first LDPC codeword sequence.

In the foregoing method, none of the column weights of the columns of the first unit, the second unit, and the third unit is greater than 1. Therefore, a receiver device may perform parallel decoding of a plurality of QC blocks, for example, parallel decoding of two QC blocks, on a codeword sequence corresponding to each unit. In addition, a case in which decoding cannot be performed does not occur. This helps improve decoding performance. In addition, only the second unit causes a waste of some hardware resources. Therefore, hardware utilization can be improved.

With reference to the first aspect, in some implementations, the outputting the second LDPC codeword sequence based on the first LDPC codeword sequence includes: performing first interleaving between a part that is in the first LDPC codeword sequence and that corresponds to an information column of the LDPC base matrix and a part that is in the first LDPC codeword sequence and that corresponds to a kernel check column of the LDPC base matrix, to obtain the second LDPC codeword sequence, where the first interleaving is performed at a granularity of columns whose quantity is a lifting value, and a quantity of second units included in a base matrix corresponding to the second LDPC codeword sequence is less than a quantity of second units included in the base matrix corresponding to the first LDPC codeword sequence; and outputting the second LDPC codeword sequence.

The first interleaving is performed at the granularity of the columns whose quantity is the lifting value, that is, the first interleaving is interleaving performed between QC blocks at a granularity of a QC block. The interleaving performed between QC blocks at a granularity of a QC block may also be referred to as QC block-level interleaving for short.

In the foregoing method, interleaving is performed between the part that is in the first LDPC codeword sequence and that corresponds to the information column of the LDPC base matrix and the part that is in the first LDPC codeword sequence and that corresponds to the kernel check column of the LDPC base matrix at a granularity of a QC block, so that the quantity of second units can be reduced. Because only the second unit causes the waste of some hardware resources, the waste of the hardware resources can be further reduced according to the method. In addition, because the interleaving is performed at a granularity of a QC block, complexity is extremely low.

With reference to any one of the first aspect or the implementations of the first aspect, in some other

implementations, when $i_1$ is less than $i_2$, $F_{i_1}$ is greater than $F_{i_2}$, $F_{i_1}$ is a value of $F_i$ when $i=i_1$, and $F_{i_2}$ is a value of $F_i$ when $i=i_2$.

According to the foregoing method, hardware resource utilization can be improved as much as possible while no performance loss at code rates is ensured.

With reference to any one of the first aspect or the implementations of the first aspect, in some other implementations, a value range of i includes a plurality of consecutive subranges, same subranges correspond to same $F_i$, and $F_i$ decreases in order of the subranges.

According to the foregoing method, on a basis of ensuring high decoding efficiency, edge density of each code rate corresponding to the LDPC base matrix can meet an edge density evolution requirement, to ensure that a decoding threshold is optimal.

With reference to any one of the first aspect or the implementations of the first aspect, in some other implementations, when i is less than a first value, $F_i$ is greater than 0; or when i is greater than or equal to a first value, $F_i$ is 0.

According to the foregoing method, as the code rate decreases, the LDPC base matrix may have greater orthogonality and a greater degree of design freedom without causing a performance loss. Based on this, $F_i$ may be 0 after the code rate is lower than a specific threshold, to improve the hardware resource utilization.

With reference to any one of the first aspect or the implementations of the first aspect, in some other implementations, when i is less than a second value, $F_i$ is 2; when i is greater than or equal to a second value and less than a third value, $F_i$ is 1; or when i is greater than or equal to a third value, $F_i$ is 0.

According to the foregoing method, for an LDPC base matrix that supports a plurality of code rate ranges, as a code rate changes, highest hardware utilization that can be achieved by an LDPC base matrix with an optimal decoding threshold also changes. As a whole, as the code rate decreases, optimization space is larger. Values of $F_i$ segments of the LDPC base matrix are respectively 2, 1, and 0. This helps achieve highest hardware resource utilization.

With reference to any one of the first aspect or the implementations of the first aspect, in some other implementations, the $M_i$ first units, the $F_i$ second units, and the $G_i$ third units are included in a non-punctured information column in the 1st column to the $x^{th}$ column of the LDPC base matrix; the $M_i$ first units, the $F_i$ second units, and the $G_i$ third units are included in an information column in the 1st column to the $x^{th}$ column of the LDPC base matrix; or the $M_i$ first units, the $F_i$ second units, and the $G_i$ third units are included in a non-punctured column in the 1st column to the $x^{th}$ column of the LDPC base matrix.

That the $M_i$ first units, the $F_i$ second units, and the $G_i$ third units are included in the non-punctured information column in the 1st column to the $x^{th}$ column of the LDPC base matrix may be understood as that only the non-punctured information column of the LDPC base matrix is limited. Because a punctured information column is highly correlated with the decoding threshold, the decoding threshold is usually preferentially ensured in a design of the punctured information column. In this way, only the non-punctured information column of the LDPC base matrix is designed, so that the hardware resource utilization can be improved while the decoding threshold is ensured.

That the $M_i$ first units, the $F_i$ second units, and the $G_i$ third units are included in the information column in the 1st column to the $x^{th}$ column of the LDPC base matrix may be understood as that all information columns of the LDPC base matrix are limited. A punctured information column and a non-punctured information column are jointly designed, so that more combination manners can be provided. This helps improve the hardware resource utilization.

That the $M_i$ first units, the $F_i$ second units, and the $G_i$ third units are included in the non-punctured column in the 1st column to the $x^{th}$ column of the LDPC base matrix may be understood as that a non-punctured information column and a non-punctured kernel check column of the LDPC base matrix are limited. The non-punctured information column and the non-punctured kernel check column of the LDPC base matrix are jointly designed, so that more combinations can be provided. Although the kernel check column has an encoding structure and cannot be used to strictly achieve extremely high hardware utilization, the kernel check column may be combined with another information column, to help form a group structure with higher hardware resource utilization.

With reference to any one of the first aspect or the implementations of the first aspect, in some other implementations, q=1.

In the foregoing method, q=1, that is, the first unit, the second unit, and the third unit each include one row. In this way, the solution of this application is also applicable to a region with high edge density in the LDPC base matrix. In addition, the first unit, the second unit, and the third unit included in the LDPC base matrix have a same scale, and the first unit is row-regular and column-regular. In this case, the LDPC base matrix has a regular structure, and a hardware decoding architecture can be simplified.

With reference to any one of the first aspect or the implementations of the first aspect, in some other implementations, a sum of shifting values of non-zero elements in the first unit is an integer multiple of the lifting value.

In an LDPC code, a cycle includes vertices connected to each other. The cycle uses one of the vertices as both a start point and an end point, and passes through each node only once. A short cycle of a node is a shortest path in cycles starting from the node. For example, if starting from a node, there are cycles whose lengths are respectively 4, 6, and 8, a short cycle of the variable node is 4. A longer length of a short cycle of a node indicates lower correlation of information sent from the node to the node, and better decoding performance. The foregoing method helps implement that the LDPC base matrix has no short cycle with a short length, for example, a short cycle whose length is 4 and a short cycle whose length is 6. This can ensure that information transfer correlation of the LDPC code is low, thereby improving the decoding performance.

With reference to any one of the first aspect or the implementations of the first aspect, in some other implementations, when the code rate is greater than a first code rate threshold, $F_i$ is 0.

According to the foregoing method, as the code rate decreases, the LDPC base matrix may have greater orthogonality and a greater degree of design freedom without causing a performance loss. Based on this, $F_i$ may be 0 after the code rate is lower than a specific threshold, to improve the hardware resource utilization.

With reference to any one of the first aspect or the implementations of the first aspect, in some other implementations, the first code rate threshold is any one of the following code rates: 0.926, $\frac{22}{24}$, $\frac{22}{25}$, or $\frac{22}{26}$.

The first code rate threshold may be a highest code rate defined in a modulation and coding scheme (Modulation and Coding Scheme, MCS) table, for example, $\frac{948}{1024} \approx 0.926$. Alternatively, the first code rate threshold may be an existing code rate of an existing base matrix, for example, $\frac{22}{24}$, $\frac{22}{25}$, or $\frac{22}{26}$ of a BG 1. In this way, a range in which a group structure is used in the LDPC base matrix may match the existing code rate. For example, the group structure in this embodiment of this application is used in a range in which the code rate is less than $\frac{22}{25}$.

With reference to any one of the first aspect or the implementations of the first aspect, in some other implementations, columns of a third subpart of the first part include a plurality of groups, a symmetric difference between non-zero elements of any two columns in each group is 0 or 1, each group includes at most one second unit, the third subpart is a matrix region including a 1st row to a uth row and a 1st column to an xth column of the first part, and u is an integer greater than or equal to 1.

According to the foregoing method, the hardware resource utilization can be improved while an optimal decoding threshold is ensured.

With reference to any one of the first aspect or the implementations of the first aspect, in some other implementations, the LDPC base matrix includes a punctured column, and a group including the punctured column includes the second unit.

The foregoing method helps ensure successful decoding of the punctured column.

With reference to any one of the first aspect or the implementations of the first aspect, in some other implementations, the LDPC base matrix includes a punctured column, and at most one of the $F_i$ second units includes the punctured column.

According to the foregoing method, when the LDPC base matrix has the punctured column, the hardware resource utilization can be improved while the optimal decoding threshold is ensured.

With reference to any one of the first aspect or the implementations of the first aspect, in some other implementations, columns of a second subpart of the first part include a plurality of groups, a symmetric difference between non-zero elements of any two columns in each group is 0 or 1, each group includes at most one second unit, the second subpart is a matrix region including the 1st row to the uth row and the 1st column to a yth column of the first part, u is an integer greater than or equal to 1, and y is less than x.

According to the foregoing method, the hardware resource utilization can be improved while the optimal decoding threshold is ensured.

With reference to any one of the first aspect or the implementations of the first aspect, in some other implementations, a matrix region corresponding to a non-punctured information column of the LDPC base matrix does not include the second unit.

According to the foregoing method, the quantity of second units may be small. This helps improve the hardware resource utilization.

With reference to any one of the first aspect or the implementations of the first aspect, in some other implementations, the first part includes a first subpart, the first subpart is a matrix region including the 1st row to the uth row and a (y+1)th column to the xth column of the first part, u is an integer greater than or equal to 1, u-1=x-y-1, and y is less than x; and diagonal elements in the first subpart are all non-zero elements, the first subpart includes N blocks, the block is a square matrix, the N blocks include all of the diagonal elements in the first subpart, a diagonal element in each of the N blocks overlaps the diagonal element in the first subpart, the blocks do not overlap, a part or all of the N blocks include a plurality of rows, and non-zero elements in at least two of the plurality of rows have a proper inclusion relationship.

According to the foregoing method, when a kernel check region has an encoding structure, the hardware resource utilization can be improved while the optimal decoding threshold is ensured.

With reference to any one of the first aspect or the implementations of the first aspect, in some other implementations, the N blocks include N1 first blocks and one second block, a size of the first block is k×k, a size of the second block is k' × k', N1 is a positive integer, N2 is a nonnegative integer, and k' is less than k.

With reference to any one of the first aspect or the implementations of the first aspect, in some other implementations, each element other than the N blocks in the first subpart is a zero element.

According to the foregoing method, a quantity of non-zero elements in the first subpart can be minimized, to achieve lowest hardware complexity.

With reference to any one of the first aspect or the implementations of the first aspect, in some other implementations, the first part includes the first subpart, the first subpart is the matrix region including the 1st row to the $u^{th}$ row and the $(y+1)^{th}$ column to the $x^{th}$ column of the first part, u is an integer greater than or equal to 1, u-1=x-y-1, and y is less than x.

When u-1=x-y-1=3, locations of zero elements and the non-zero elements in the first subpart are shown in any one of the following matrices:

$$\begin{bmatrix} 1 & 1 & 0 \\ 0 & 1 & 0 \\ 0 & 0 & 1 \end{bmatrix};$$

when u-1=x-y-1=4, locations of zero elements and the non-zero elements in the first subpart are shown in either of the following matrices:

$$\begin{bmatrix} 1 & 1 & 0 & 0 \\ 0 & 1 & 0 & 0 \\ 0 & 0 & 1 & 1 \\ 0 & 0 & 0 & 1 \end{bmatrix}, \begin{bmatrix} 1 & 1 & 1 & 0 \\ 0 & 1 & 1 & 0 \\ 0 & 0 & 1 & 0 \\ 0 & 0 & 0 & 1 \end{bmatrix};$$

and/or

when u-1=x-y-1=5, locations of zero elements and the non-zero elements in the first subpart are shown in any one of the following matrices:

$$\begin{bmatrix} 1 & 1 & 0 & 0 & 0 \\ 0 & 1 & 0 & 0 & 0 \\ 0 & 0 & 1 & 1 & 0 \\ 0 & 0 & 0 & 1 & 0 \\ 0 & 0 & 0 & 0 & 1 \end{bmatrix}, \begin{bmatrix} 1 & 1 & 1 & 0 & 0 \\ 0 & 1 & 1 & 0 & 0 \\ 0 & 0 & 1 & 0 & 0 \\ 0 & 0 & 0 & 1 & 1 \\ 0 & 0 & 0 & 0 & 1 \end{bmatrix}, \text{or} \begin{bmatrix} 1 & 1 & 1 & 1 & 0 \\ 0 & 1 & 1 & 1 & 0 \\ 0 & 0 & 1 & 1 & 0 \\ 0 & 0 & 0 & 1 & 0 \\ 0 & 0 & 0 & 0 & 1 \end{bmatrix}.$$

In the foregoing matrices, "1" represents a non-zero element, and "0" represents a non-zero element.

With reference to any one of the first aspect or the implementations of the first aspect, in some other implementations, q=k.

With reference to any one of the first aspect or the implementations of the first aspect, in some other implementations, a row weight of each row of the first unit is 1.

According to the foregoing method, the first unit, the second unit, and the third unit included in the LDPC base matrix have a same scale, and the first unit is row-regular and column-regular. In this case, the LDPC base matrix has a regular structure, and a hardware decoding architecture can be simplified.

With reference to any one of the first aspect or the implementations of the first aspect, in some other implementations, each first unit is obtained through permutation of a sequence θ ($\theta_1$, $\theta_2$, ..., $\theta_a$, ..., $\theta_k$) whose length is k, the $a^{th}$ element $\theta_a$ of θ represents that an element in an $a^{th}$ row and a $(\theta_a)^{th}$ column of the first unit is a non-zero element, and a is an integer greater than 0 and less than or equal to k.

In the foregoing method, each first unit may be obtained in a permutation manner. This brings a simple implementation.

With reference to any one of the first aspect or the implementations of the first aspect, in some other implementations, $\theta_a$=a+b(mod k), or $\theta_a$=k+1-a+b(mod k), where b is a constant.

The foregoing method helps implement that the LDPC base matrix has no short cycle with a short length, for example, a short cycle whose length is 4 and a short cycle whose length is 6. This can ensure that information transfer correlation of the LDPC code is low, thereby improving the decoding performance.

With reference to any one of the first aspect or the implementations of the first aspect, in some other implementations, shifting values of non-zero elements in the first unit are the same; remainders of any two non-zero elements in the first unit relative to the lifting value are the same; or a sum of shifting values of non-zero elements in the first unit is an integer multiple of the lifting value.

The foregoing method helps implement that the LDPC base matrix has no short cycle with a short length, for example, a short cycle whose length is 4 and a short cycle whose length is 6. This can ensure that information transfer correlation of the LDPC code is low, thereby improving the decoding performance.

With reference to any one of the first aspect or the implementations of the first aspect, in some other implementations, each first unit includes K segments, the K segments are divided by column, an intersection set of any two of the K segments is empty, a union set of the K segments is the first unit, K is greater than or equal to 2, and a $c^{th}$ segment of the K segments is obtained through permutation of a sequence $\theta^c$ ($\theta_1^c$, $\theta_2^c$, ..., $\theta_a^c$, ..., $\theta_{K^c}^c$) whose length is $|K^c|$, where the $a^{th}$ element $\theta_a^c$ of $\theta^c$ represents that an element in an $a^{th}$ row and a ($\theta_a^c$)$^{th}$ column of the $c^{th}$ segment is a non-zero element, $|K^c|$ is a quantity of columns of the $c^{th}$ segment, c is an integer greater than 0 and less than or equal to K, and a is an integer greater than 0 and less than or equal to $K^c$.

The foregoing method provides a base graph structure that is easy for a design of a hardware quasi-cyclic low density parity check (quasi-cyclic low density parity check, QC-LDPC) rotation network.

With reference to any one of the first aspect or the implementations of the first aspect, in some other implementations, $\theta_a^c = a + b^c (\mathrm{mod}|K^c|)$, or $\theta_a^c = |K^c| + 1 - a + b^c (\mathrm{mod}|K^c|)$, where $b^c$ is a constant corresponding to the $c^{th}$ segment.

The foregoing method provides a shifting value design scheme corresponding to the segment permutation manner of the first unit of the LDPC base matrix, to jointly support QC-LDPC.

With reference to any one of the first aspect or the implementations of the first aspect, in some other implementations, each first unit includes K segments, the K segments are divided by column, an intersection set of any two of the K segments is empty, a union set of the K segments is the first unit, K is greater than or equal to 2, and shifting values of non-zero elements of the segments are the same; or remainders of any two non-zero elements of the segments relative to the lifting value are the same; or a sum of shifting values of non-zero elements of the segments is an integer multiple of the lifting value.

The foregoing method helps avoid short cycles with a short length in the LDPC base matrix, for example, a short cycle whose length is 4 and a short cycle whose length is 6, thereby improving the decoding performance of the LDPC code and reducing an error floor.

With reference to any one of the first aspect or the implementations of the first aspect, in some other implementations, when q=k=2, locations of zero elements and the non-zero elements in the first unit are shown in either of the following matrices: $\begin{bmatrix} 1 & 0 \\ 0 & 1 \end{bmatrix}$ or $\begin{bmatrix} 0 & 1 \\ 1 & 0 \end{bmatrix}$, where in the matrices, "1" represents a non-zero element, and "0" represents a non-zero element.

With reference to any one of the first aspect or the implementations of the first aspect, in some other implementations, when q=k=3, locations of zero elements and the non-zero elements in the first unit are shown in any one of the following matrices:

$$\begin{bmatrix} 1 & 0 & 0 \\ 0 & 1 & 0 \\ 0 & 0 & 1 \end{bmatrix}, \begin{bmatrix} 1 & 0 & 0 \\ 0 & 0 & 1 \\ 0 & 1 & 0 \end{bmatrix}, \begin{bmatrix} 0 & 1 & 0 \\ 1 & 0 & 0 \\ 0 & 0 & 1 \end{bmatrix}, \begin{bmatrix} 0 & 1 & 0 \\ 0 & 0 & 1 \\ 1 & 0 & 0 \end{bmatrix}, \begin{bmatrix} 0 & 0 & 1 \\ 1 & 0 & 0 \\ 0 & 1 & 0 \end{bmatrix}, \text{or} \begin{bmatrix} 0 & 0 & 1 \\ 0 & 1 & 0 \\ 1 & 0 & 0 \end{bmatrix}.$$

In the matrices, "1" represents a non-zero element, and "0" represents a non-zero element.

With reference to any one of the first aspect or the implementations of the first aspect, in some other implementations, when q=k=4, locations of zero elements and the non-zero elements in the first unit are shown in any one of the following matrices:

$$\begin{bmatrix} 1 & 0 & 0 & 0 \\ 0 & 1 & 0 & 0 \\ 0 & 0 & 1 & 0 \\ 0 & 0 & 0 & 1 \end{bmatrix}, \begin{bmatrix} 1 & 0 & 0 & 0 \\ 0 & 1 & 0 & 0 \\ 0 & 0 & 0 & 1 \\ 0 & 0 & 1 & 0 \end{bmatrix}, \begin{bmatrix} 1 & 0 & 0 & 0 \\ 0 & 0 & 1 & 0 \\ 0 & 1 & 0 & 0 \\ 0 & 0 & 0 & 1 \end{bmatrix}, \begin{bmatrix} 1 & 0 & 0 & 0 \\ 0 & 0 & 1 & 0 \\ 0 & 0 & 0 & 1 \\ 0 & 1 & 0 & 0 \end{bmatrix}, \begin{bmatrix} 1 & 0 & 0 & 0 \\ 0 & 0 & 0 & 1 \\ 0 & 1 & 0 & 0 \\ 0 & 0 & 1 & 0 \end{bmatrix},$$

$$\begin{bmatrix} 1 & 0 & 0 & 0 \\ 0 & 0 & 0 & 1 \\ 0 & 0 & 1 & 0 \\ 0 & 1 & 0 & 0 \end{bmatrix}, \begin{bmatrix} 0 & 1 & 0 & 0 \\ 1 & 0 & 0 & 0 \\ 0 & 0 & 1 & 0 \\ 0 & 0 & 0 & 1 \end{bmatrix}, \begin{bmatrix} 0 & 1 & 0 & 0 \\ 1 & 0 & 0 & 0 \\ 0 & 0 & 1 & 0 \\ 0 & 0 & 0 & 1 \end{bmatrix}, \begin{bmatrix} 0 & 1 & 0 & 0 \\ 0 & 0 & 1 & 0 \\ 0 & 0 & 0 & 1 \\ 1 & 0 & 0 & 0 \end{bmatrix}, \begin{bmatrix} 0 & 1 & 0 & 0 \\ 0 & 0 & 1 & 0 \\ 1 & 0 & 0 & 0 \\ 0 & 0 & 0 & 1 \end{bmatrix},$$

$$\begin{bmatrix} 0 & 1 & 0 & 0 \\ 0 & 0 & 0 & 1 \\ 1 & 0 & 0 & 0 \\ 0 & 0 & 1 & 0 \end{bmatrix}, \begin{bmatrix} 0 & 1 & 0 & 0 \\ 0 & 0 & 0 & 1 \\ 0 & 0 & 1 & 0 \\ 1 & 0 & 0 & 0 \end{bmatrix}, \begin{bmatrix} 0 & 0 & 1 & 0 \\ 1 & 0 & 0 & 0 \\ 0 & 1 & 0 & 0 \\ 0 & 0 & 0 & 1 \end{bmatrix}, \begin{bmatrix} 0 & 0 & 1 & 0 \\ 1 & 0 & 0 & 0 \\ 0 & 0 & 0 & 1 \\ 0 & 1 & 0 & 0 \end{bmatrix}, \begin{bmatrix} 0 & 0 & 1 & 0 \\ 0 & 1 & 0 & 0 \\ 0 & 0 & 0 & 1 \\ 1 & 0 & 0 & 0 \end{bmatrix},$$

$$\begin{bmatrix} 0 & 0 & 1 & 0 \\ 0 & 1 & 0 & 0 \\ 1 & 0 & 0 & 0 \\ 0 & 0 & 0 & 1 \end{bmatrix}, \begin{bmatrix} 0 & 0 & 1 & 0 \\ 0 & 0 & 0 & 1 \\ 1 & 0 & 0 & 0 \\ 0 & 1 & 0 & 0 \end{bmatrix}, \begin{bmatrix} 0 & 0 & 1 & 0 \\ 0 & 0 & 0 & 1 \\ 0 & 1 & 0 & 0 \\ 1 & 0 & 0 & 0 \end{bmatrix}, \begin{bmatrix} 0 & 0 & 0 & 1 \\ 1 & 0 & 0 & 0 \\ 0 & 1 & 0 & 0 \\ 0 & 0 & 1 & 0 \end{bmatrix}, \begin{bmatrix} 0 & 0 & 0 & 1 \\ 1 & 0 & 0 & 0 \\ 0 & 0 & 1 & 0 \\ 0 & 1 & 0 & 0 \end{bmatrix},$$

$$\begin{bmatrix} 0 & 0 & 0 & 1 \\ 0 & 1 & 0 & 0 \\ 0 & 0 & 1 & 0 \\ 1 & 0 & 0 & 0 \end{bmatrix}, \begin{bmatrix} 0 & 0 & 0 & 1 \\ 0 & 1 & 0 & 0 \\ 1 & 0 & 0 & 0 \\ 0 & 0 & 1 & 0 \end{bmatrix}, \begin{bmatrix} 0 & 0 & 0 & 1 \\ 0 & 0 & 1 & 0 \\ 0 & 1 & 0 & 0 \\ 1 & 0 & 0 & 0 \end{bmatrix}, \text{ or } \begin{bmatrix} 0 & 0 & 0 & 1 \\ 0 & 0 & 1 & 0 \\ 1 & 0 & 0 & 0 \\ 0 & 1 & 0 & 0 \end{bmatrix}.$$

In the foregoing matrices, "1" represents a non-zero element, and "0" represents a non-zero element.

With reference to any one of the first aspect or the implementations of the first aspect, in some other implementations, the LDPC base matrix is obtained based on an indicator matrix, one element in the indicator matrix corresponds to one element in the first unit, the second unit, or the third unit, and a value of the element in the indicator matrix indicates locations/a location of a zero element and/or a non-zero element that are/is in the first unit, the second unit, or the third unit and that correspond/corresponds to the element.

In other words, the LDPC base matrix may be represented by a smaller indicator matrix. This helps reduce storage content of the device.

With reference to any one of the first aspect or the implementations of the first aspect, in some other implementations, a row number of a row in a matrix region including the first unit, the second unit, and the third unit is greater than a row number of a row in a matrix region corresponding to a first code rate, and the first code rate is greater than a code rate threshold.

Because a kernel matrix of the LDPC base matrix has high edge density, a group structure that can be used generally needs to be limited to q=1. In other words, if a first region includes the kernel matrix, a group structure that can be used in the first region generally needs to be limited to q=1. As a row number increases, edge density of the LDPC base matrix decreases. Therefore, if a group structure is used only in a range (for example, an extension region) in which a row number is greater than a row number threshold, compatibility with more types of group structures may be implemented, and the group structure is not limited to a group structure in which q=1. Therefore, the design is more flexible.

With reference to any one of the first aspect or the implementations of the first aspect, in some other implementations, $F_i$ is related to at least one of the following information: code rates corresponding to the $(q \times (i-1)+1)^{th}$ row to the $(q \times i)^{th}$ row, row weights of the $(q \times (i-1)+1)^{th}$ row to the $(q \times i)^{th}$ row, or locations/a location of a zero element and/or a non-zero element in the $(q \times (i-1)+1)^{th}$ row to the $(q \times i)^{th}$ row of the punctured column of the LDPC base matrix.

With reference to any one of the first aspect or the implementations of the first aspect, in some other implementations, the row weights of the $(q \times (i-1)+1)^{th}$ row to the $(q \times i)^{th}$ row include at least one of the following information: row weights of the $(q \times (i-1)+1)^{th}$ row to the $(q \times i)^{th}$ row in which a punctured column included in the LDPC base matrix is included; row weights of the $(q \times (i-1)+1)^{th}$ row to the $(q \times i)^{th}$ row in which a punctured column included in the LDPC base matrix is not included; or row weights of the $(q \times (i-1)+1)^{th}$ row to the $(q \times i)^{th}$ row when the LDPC base matrix includes no punctured column.

According to a second aspect, an LDPC code-based communication method is provided. The method may be performed by a receiver device, or may be performed by a module or a unit (for example, a chip) in the receiver device. For ease of description, the following uses the receiver device for description. The receiver device may be a terminal device or a network device.

The method includes: receiving a second LDPC codeword sequence; and decoding the second LDPC codeword sequence based on an LDPC base matrix, where a $(q \times (i-1)+1)^{th}$ row to a $(q \times i)^{th}$ row of a first part of the LDPC base matrix include $M_i$ first units, $F_i$ second units, and $G_i$ third units; the first part is a matrix region including a $1^{st}$ column to an $x^{th}$ column of the LDPC base matrix; the first unit is a matrix with q rows and k columns, and a column weight of each column is 1; the second unit is a matrix with q rows and k columns, a column weight of at least one column of the second unit is 1, and a column weight of a remaining column is 0; the third unit is a matrix with q rows and k columns, and a column weight of each column is 0; i and q are positive integers; x and k are integers greater than or equal to 2; $M_i$ is a positive integer; and $F_i$ and $G_i$ are nonnegative integers.

In the foregoing method, none of the column weights of the columns of the first unit, the second unit, and the third unit is greater than 1. Therefore, the receiver device may perform parallel decoding of a plurality of QC blocks, for example, parallel decoding of two QC blocks, on a codeword sequence corresponding to each unit. In addition, a case in which decoding cannot be performed does not occur. This helps improve decoding performance. In addition, only the second unit causes a waste of some hardware resources. Therefore, hardware utilization can be improved.

With reference to the second aspect, in some implementations, the decoding the second LDPC codeword sequence based on the LDPC base matrix includes: performing first column transformation between an information column and a kernel check column of the LDPC base matrix, where the first column transformation is performed at a granularity of columns whose quantity is a lifting value, and a quantity of second units included in an LDPC base matrix obtained through the first column transformation is less than a quantity of second units included in the LDPC base matrix on which no first column transformation is performed; and decoding the second LDPC codeword sequence based on the LDPC base matrix obtained through the first column transformation.

The first column transformation is performed at the granularity of the columns whose quantity is the lifting value, that is, the first column transformation is column transformation performed between QC blocks at a granularity of a QC block. The column transformation performed between QC blocks at a granularity of a QC block may also be referred to as QC block-level column transformation for short. The waste of the hardware resources can be further reduced according to the method. In addition, because the first column transformation is performed at a granularity of a QC block, complexity is extremely low.

With reference to any one of the second aspect or the implementations of the second aspect, in some other implementations, the decoding the second LDPC codeword sequence based on the LDPC base matrix includes: performing first de-interleaving on the second LDPC codeword sequence, where the first de-interleaving is performed at a granularity of columns whose quantity is a lifting value, to obtain a first LDPC codeword sequence; and decoding the first LDPC codeword sequence based on the LDPC base matrix. The first de-interleaving is performed at the granularity of the columns whose quantity is the lifting value, that is, the first de-interleaving is de-interleaving performed between QC blocks at a granularity of a QC block. The de-interleaving performed between QC blocks at a granularity of a QC block may also be referred to as QC block-level de-interleaving for short.

With reference to any one of the second aspect or the implementations of the second aspect, in some other implementations, the decoding the second LDPC codeword sequence based on the LDPC base matrix includes: using a same storage unit and computing unit to perform parallel decoding on elements that are in the second LDPC codeword sequence and that correspond to those in the first unit, the second unit, or the third unit, where the storage unit and the computing unit are a storage unit and a computing unit of one QC block.

In the foregoing method, the same storage unit and computing unit may be used to perform parallel decoding on a plurality of elements in the first unit, the second unit, or the third unit, and there is no need to process another element after one element is processed. Therefore, a delay of processing the plurality of elements is consistent with a delay of processing one element separately. This helps improve the decoding performance.

For terms or features in the second aspect or the implementations of the second aspect that are the same as those in the first aspect or the implementations of the first aspect, refer to the first aspect or the implementations of the first aspect. For technical effects thereof, refer to the technical effects of the first aspect or the implementations of the first aspect. Details are not described in the second aspect again.

According to a third aspect, a communication apparatus is provided. The apparatus is configured to perform the method provided in any one of the foregoing aspects or the implementations of the foregoing aspects. Specifically, the apparatus may include a unit and/or a module configured to perform the method provided in any one of the foregoing aspects or the implementations of the foregoing aspects, for example, a processing unit and/or a transceiver unit.

In an implementation, the apparatus is a transmitter device or a receiver device. When the apparatus is the transmitter device or the receiver device, the transceiver unit may be a transceiver, an input/output interface, or a communication interface; and the processing unit may be at least one processor. Optionally, the transceiver is a transceiver circuit. Optionally, the input/output interface is an input/output circuit.

In another implementation, the apparatus is a chip, a chip system, or a circuit used in the transmitter device or the receiver device. When the apparatus is the chip, the chip system, or the circuit used in the transmitter device or the receiver device, the transceiver unit may be an input/output interface, an interface circuit, an output circuit, an input circuit, a pin, a related circuit, or the like on the chip, the chip system, or the circuit; and the processing unit may be at least one processor, a processing circuit, a logic circuit, or the like.

According to a fourth aspect, a communication apparatus is provided. The apparatus includes: a storage, configured to store a program; and at least one processor, configured to execute the computer program or instructions stored in the storage, to perform the method provided in any one of the foregoing aspects or the implementations of the foregoing aspects.

In an implementation, the apparatus is a transmitter device or a receiver device.

In another implementation, the apparatus is a chip, a chip system, or a circuit used in the transmitter device or the receiver device.

According to a fifth aspect, a communication apparatus is provided. The apparatus includes at least one processor and a communication interface. The at least one processor is configured to obtain, through the communication interface, a computer program or instructions stored in a storage, to perform the method provided in any one of the foregoing aspects or the implementations of the foregoing aspects. The communication interface may be implemented by hardware or software.

In an implementation, the apparatus further includes the storage.

According to a sixth aspect, a processor is provided, and is configured to perform the methods provided in the foregoing aspects.

Operations such as sending and obtaining/receiving related to the processor may be understood as operations such as outputting and receiving or inputting of the processor, or may be understood as operations such as sending and receiving performed by a radio frequency circuit and an antenna, unless otherwise specified, or provided that the operations do not contradict actual functions or internal logic of the operations in related descriptions. This is not limited in this application.

According to a seventh aspect, a computer-readable storage medium is provided. The computer-readable medium stores program code to be executed by a device. The program code is used to perform the method provided in any one of the foregoing aspects or the implementations of the foregoing aspects.

According to an eighth aspect, a computer program product including instructions is provided. When the computer program product runs on a computer, the computer is enabled to perform the method provided in any one of the foregoing aspects or the implementations of the foregoing aspects.

According to a ninth aspect, a chip is provided. The chip includes a processor and a communication interface. The processor reads, through the communication interface, instructions stored in a storage, to perform the method provided in any one of the foregoing aspects or the implementations of the foregoing aspects. The communication interface may be implemented by hardware or software.

Optionally, in an implementation, the chip further includes the storage. The storage stores a computer program or the instructions. The processor is configured to execute the computer program or the instructions stored in the storage. When the computer program or the instructions are executed, the processor is configured to perform the method provided in any one of the foregoing aspects or the implementations of the foregoing aspects.

When the method provided in this application is performed by the chip, a quantity of chips that specifically implement the method in this application is not limited in this application. For example, the method may be performed by one chip, or may be performed by two or more chips. In addition, when there are two or more chips that implement the method in this application, a chip vendor is not limited. The chips may be from a same vendor or from different vendors.

According to a tenth aspect, a communication system is provided, and includes at least one of the transmitter device or the receiver device described above.

According to an eleventh aspect, a computer program is provided. When the computer program is run on a computer, the method provided in any one of the foregoing aspects or the implementations of the foregoing aspects is performed.

**BRIEF DESCRIPTION OF DRAWINGS**

FIG. 1 is a diagram of a network architecture to which an embodiment of this application may be applied;
FIG. 2 is a diagram of an LDPC check matrix H;
FIG. 3 is a Tanner (Tanner) graph of an LDPC check matrix H;
FIG. 4 is a diagram of a structure of a check matrix;
FIG. 5 shows an example of a column-irregular group structure and a column-regular group structure;
FIG. 6 shows an example of a row-irregular group structure and a row-regular group structure;
FIG. 7 is a diagram of a matrix using a group structure 1 in which k=2;
FIG. 8 is a diagram of a matrix using a group structure 2 in which k=2;
FIG. 9 is a diagram of an information transmission procedure;
FIG. 10 is a schematic flowchart of an LDPC code-based communication method 1000 according to this application;
FIG. 11 is a diagram of hardware decoding architectures corresponding to a group structure 1 and a group structure 2;

FIG. 12 is a diagram of an encoding chain according to this application;

FIG. 13 is a diagram of interleaving between QC blocks that is performed between an information column and a kernel check column;

FIG. 14 shows an example of grouping kernel columns;

FIG. 15 is a diagram of dividing a part B into blocks;

FIG. 16 is a line graph of a quantity change of column-irregular group structures at different code rates;

FIG. 17 shows simulation results of quantities of equivalently decoded QC blocks of LDPC codes at different code rates;

FIG. 18 shows simulation results of signal-to-noise ratios (signal-noise ratios, SNRs) of LDPC codes at different code rates;

FIG. 19 shows simulation results 1 of signal-to-noise ratios of LDPC codes with different code lengths at different code rates;

FIG. 20 shows simulation results 2 of signal-to-noise ratios of LDPC codes with different code lengths at different code rates;

FIG. 21 shows simulation results 3 of signal-to-noise ratios of LDPC codes with different code lengths at different code rates;

FIG. 22 is a diagram of a structure of an apparatus according to an embodiment of this application;

FIG. 23 is a diagram of another structure of an apparatus according to an embodiment of this application; and

FIG. 24 is a diagram of a chip system according to an embodiment of this application.

## DESCRIPTION OF EMBODIMENTS

For ease of understanding embodiments of this application, before embodiments of this application are described, the following descriptions are first provided.

"Indicating" or "indicate" may include direct indicating and indirect indicating, or "indicating" or "indicate" may be explicitly and/or implicitly indicating. Various numbers such as first and second are merely used for differentiation for ease of description, and are not used to limit the scope of embodiments of this application, for example, to distinguish between different messages and different information. "Predefinition" may be implemented by pre-storing corresponding code or a corresponding table in a device, or may be implemented in another manner that may indicate related information. A specific implementation of the predefinition is not limited in this application. A related "protocol" may be a standard protocol in the communication field, for example, may include a long term evolution (long term evolution, LTE) protocol, an NR protocol, and a related protocol applied to a future communication system. This is not limited in this application. The words such as "for example", "example", and "in an (another) example" are used to represent giving an example, an illustration, or a description. Any embodiment or design scheme described as an "example" in this application should not be explained as being more preferred or having more advantages than another embodiment or design scheme. The terms "include", "have", and their variants all mean "including but not limited to", unless otherwise specifically emphasized in another manner. "At least one" means one or more, and "a plurality of' means two or more. "At most one" means one or zero. The term "and/or" describes an association relationship between associated objects, and represents that three relationships may exist. For example, A and/or B may represent the following cases: Only A exists, both A and B exist, and only B exists, where A and B may be singular or plural. The character "/" generally indicates an "or" relationship between the associated objects. "At least one of the following items (pieces)" or a similar expression thereof indicates any combination of these items, including a single item (piece) or any combination of a plurality of items (pieces). For example, at least one of a, b, and c may indicate a, b, c, a and b, a and c, b and c, or a, b, and c. Each of a, b, and c may be singular or plural. Related descriptions about sending a message, information, or data by a network element A to a network element B, and receiving, by the network element B, the message, the information, or the data from the network element A are intended to describe a network element to which the message, the information, or the data is to be sent. Whether the message, the information, or the data is directly sent or indirectly sent via another network element is not limited. Descriptions such as "when...", "in a case of...", and "if" all mean that a device performs corresponding processing in an objective case, are not intended to limit time, do not require a determining action during implementation of the device, and do not mean that there is another limitation.

In addition, a network architecture and a service scenario described in embodiments of this application are intended to describe the technical solutions in embodiments of this application more clearly, and do not constitute a limitation on the technical solutions provided in embodiments of this application. A person of ordinary skill in the art may know that with evolution of the network architecture and emergence of a new service scenario, the technical solutions provided in embodiments of this application are also applicable to similar technical problems.

The following describes a communication system to which embodiments of this application may be applied.

Embodiments of this application may be applied to various communication systems, including but not limited to a 5th generation (5th generation, 5G) system, an NR system, an LTE system, a long term evolution-advanced (long term evolution-advanced, LTE-A) system, an LTE frequency division duplex (frequency division duplex, FDD) system, an LTE time division duplex (time division duplex, TDD) system, and the like. Embodiments of this application may be further applied to a future communication system, for example, a 6th generation mobile communication system. In addition, embodiments of this application may be further applied to device-to-device (device-to-device, D2D) communication, vehicle-to-everything (vehicle-to-everything, V2X) communication, machine-to-machine (machine-to-machine, M2M) communication, machine type communication (machine type communication, MTC), an internet of things (internet of things, IoT) communication system, or another communication system. In addition, embodiments of this application may be further extended to similar wireless communication systems, for example, communication systems related to wireless fidelity (wireless fidelity, Wi-Fi), worldwide interoperability for microwave access (worldwide interoperability for microwave access, WiMAX), and a 3rd generation partnership project (3rd generation partnership project, 3GPP). This is not limited.

The communication system applicable to embodiments of this application may include one or more transmitter devices and one or more receiver devices. Optionally, one of the transmitter device and the receiver device may be a terminal device, and the other may be a network device. Optionally, both the transmitter device and the receiver device may be terminal devices. Optionally, both the transmitter device and the receiver device may be network devices.

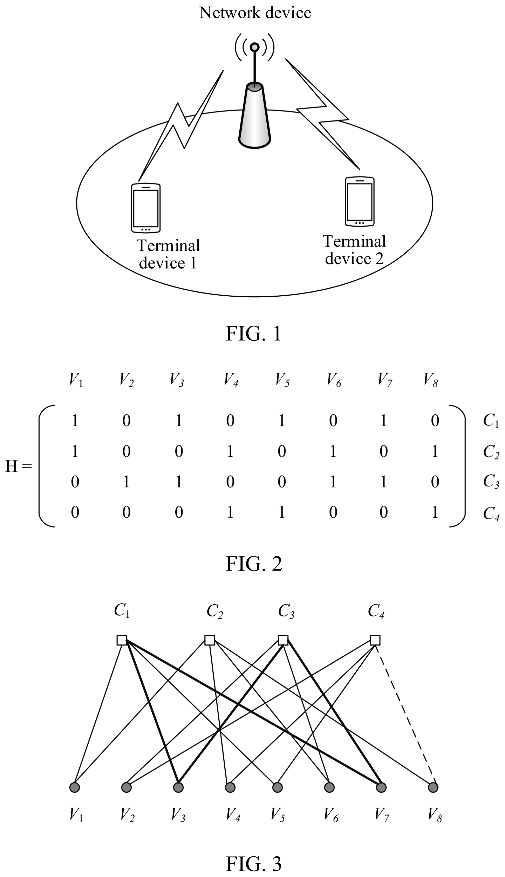

For example, FIG. 1 is a diagram of a network architecture to which an embodiment of this application is applicable.

As shown in FIG. 1, embodiments of this application are applicable to both uplink data transmission and downlink data transmission. In FIG. 1, only uplink data transmission or downlink data transmission between one network device and two terminal devices (for example, a terminal device 1 and a terminal device 2) is used as an example. In the uplink data transmission, in this specification, a transmitter device is the terminal device, and a receiver device is the network device. On the contrary, in the downlink data transmission, a transmitter device is the network device, and a receiver device is the terminal device. In addition, applicability of embodiments of this application in another communication scenario is not limited. For example, embodiments of this application may also be applied to sidelink communication.

The terminal device in this application may also be referred to as user equipment (user equipment, UE), an access terminal, a subscriber unit, a subscriber station, a mobile station, a mobile terminal (mobile terminal, MT), a remote station, a remote terminal, a mobile device, a user terminal, a terminal, an uncrewed aerial vehicle, a wireless communication device, a user agent, a user apparatus, or the like. The terminal device in embodiments of this application may be a device that provides voice and/or data connectivity for a user, and may be configured to connect a person, an object, and a machine, for example, a handheld device or a vehicle-mounted device having a wireless connection function. The terminal device in embodiments of this application may be a mobile phone (mobile phone), a pad (pad), a notebook computer, a palmtop computer, a mobile internet device (mobile internet device, MID), a wearable device, a virtual reality (virtual reality, VR) device, an augmented reality (augmented reality, AR) device, a wireless terminal in industrial control (industrial control), a wireless terminal in self-driving (self-driving), a wireless terminal in remote medical surgery (remote medical surgery), a wireless terminal in a smart grid (smart grid), a wireless terminal in transportation safety (transportation safety), a wireless terminal in a smart city (smart city), a wireless terminal in a smart home (smart home), or the like.

The network device in this application may be a device having a wireless transceiver function. The network device may be a device that provides a wireless communication function service, is usually located on a network side, and includes but is not limited to a next generation NodeB (gNodeB, gNB) in a 5G system, a base station in a 6th generation mobile communication system, a base station in a future mobile communication system, an access node in a wireless fidelity (wireless fidelity, Wi-Fi) system, an evolved NodeB (evolved NodeB, eNB) in a long term evolution (long term evolution, LTE) system, a radio network controller (radio network controller, RNC), a NodeB (NodeB, NB), a base station controller (base station controller, BSC), a home base station (for example, a home evolved NodeB, or a home NodeB, HNB), a baseband unit (baseband unit, BBU), a transmission reception point (transmission reception point, TRP), a transmission point (transmission point, TP), a base transceiver station (base transceiver station, BTS), a satellite, an uncrewed aerial vehicle, and the like. In a network structure, the network device may include a central unit (central unit, CU) node or a distributed unit (distributed unit, DU) node; or may be a RAN device including a CU node and a DU node, or a RAN device including a CU-control plane node, a CU-user plane node, and a DU node. Alternatively, the network device may be a radio controller, a relay station, a vehicle-mounted device, a wearable device, or the like in a cloud radio access network (cloud radio access network, CRAN) scenario. In addition, the base station may be a macro base station, a micro base station, a relay node, a donor node, or a combination thereof. The base station may alternatively be a communication module, a modem, or a chip disposed in the foregoing device or apparatus. The base station may alternatively be a mobile switching center, a device that bears a base station function in D2D, V2X, and M2M communication, a network side device in a 6G network, a device that bears a base station function in a future communication system, or the like. The base station can support networks using a same access technology or different access technologies. This is not limited.

Unless otherwise specified, in this application, an apparatus configured to implement a function of the terminal device or the network device may be the terminal device or the network device, or may be an apparatus that can support the terminal device or the network device in implementing the function, for example, a chip system or a chip. Specifically, the apparatus is a system on a chip (system on a chip, SoC) or a modem (Modem). The apparatus may be installed in the terminal device or the network device. In embodiments of this application, the chip system may include a chip, or may include a chip and another discrete device.

It should be further noted that in some embodiments of this specification, a 5G system is used as an example to describe specific details of solutions. It may be understood that when the solutions are applied to another communication system, for example, an LTE system or a future communication system, messages, channels, information, or the like in the solutions may be replaced with messages, channels, information, or the like that can be used to implement corresponding functions in the another communication system. This is not limited in this application.

For ease of understanding embodiments of this application, several concepts or terms in embodiments of this application are briefly described. The concepts or the terms described below are described based on concepts or terms specified in a protocol. However, this does not mean that embodiments of this application can be applied only to a current existing system, and the concepts or the terms in embodiments of this application can be applied to a future system. In addition, specific names of the concepts or the terms (for example, concepts or terms related to functional descriptions) may be adjusted with development of the future system.

1. LDPC code

The LDPC code is a linear block code, and a check matrix of the LDPC code is a sparse matrix. In the LDPC check matrix, a quantity of zero elements is far greater than a quantity of non-zero elements. In other words, a row weight and a column weight of the check matrix are much less than an LDPC code length. An LDPC code whose information bit sequence length is equal to w and whose code length is equal to v may be uniquely determined based on a check matrix of the LDPC code.

In 1981, Tanner represented an LDPC codeword in a graph. This graph now is referred to as a Tanner graph, and the Tanner graph and the check matrix are in one-to-one correspondence. The Tanner graph includes two types of vertices. One type of vertex represents a codeword bit and is referred to as a variable node. The other type of vertex is a check node and represents a check constraint relationship. Each check node represents one check constraint relationship. The following provides descriptions with reference to FIG. 2 and FIG. 3.

FIG. 2 is a diagram of an LDPC check matrix H.

In FIG. 2, $\{V_i\}$ represents a variable node (variable node, VN) set, and $\{C_i\}$ represents a check node (check node, CN) set. In the check matrix H, each row represents one check equation, each check equation corresponds to one check node, each column represents one codeword bit, and each codeword bit corresponds to one variable node. In FIG. 2, there are eight variable nodes and four check nodes. If a codeword bit is included in a corresponding check equation, a related variable node and check node are connected by using a connection line, to obtain a Tanner graph.

FIG. 3 is a Tanner graph of an LDPC check matrix H.

As shown in FIG. 3, the Tanner graph represents the LDPC check matrix. For example, for the check matrix H with a size of g rows and v columns, the Tanner graph includes two types of nodes: v variable nodes and g check nodes. The v variable nodes respectively correspond to the v columns of the check matrix H, and the g check nodes respectively correspond to the g rows of the check matrix H. In the Tanner graph, a cycle includes vertices connected to each other. The cycle uses one of the vertices as both a start point and an end point, and passes through each node only once. A length of the cycle is defined as a quantity of connection lines included in the cycle. A girth of a graph may also be referred to as a size of the graph, and is defined as a shortest cycle length in the graph. For example, in FIG. 3, a girth is 4, as shown by a bold connection line in FIG. 3. The variable nodes in the Tanner graph each correspond to one column of the check matrix H, that is, correspond to one LDPC codeword bit. The check nodes in the Tanner graph each correspond to one row of the check matrix H, that is, correspond to one LDPC check bit. A connection status between the two types of nodes corresponds to a value of an element in the matrix H. If there is a connection between an $i^{th}$ check node and a $j^{th}$ variable node, it indicates that a value of an element (i, j) in the matrix H is 1. If there is no connection, a corresponding element is 0. A connection line between the variable node and the check node may also be referred to as an edge. That there is the connection between the check node and the variable node may also be described as that there is a connection or an edge between the check node and the variable node. An edge relationship between the check node and the variable node may include two cases: there is an edge or there is no edge.

In addition, in the Tanner graph, the cycle (cycle) is a closed loop including a variable node, a check node, and an edge that are connected end to end.

As described above, the LDPC is a linear block code. In the linear block code, a to-be-encoded information sequence is divided into groups in a unit of w bits, and an encoder performs a linear operation on the w information bits to obtain g check bits. Then, the w information bits are combined with the g check bits to obtain a codeword whose length is v=w+g. A mapping relationship between the w-bit information bits and the codeword whose length is v bits is usually represented by a corresponding check matrix H. A codeword sequence may be correspondingly generated based on the check matrix H to complete an encoding process. After the codeword sequence is transmitted through a channel, a receiver device correspondingly decodes a received signal, to determine an original information bit.

2. QC-LDPC code

The QC-LDPC code is a structured LDPC code. Due to a unique structure of a check matrix of the QC-LDPC code, a simple feedback shift register can be used for encoding, to reduce encoding complexity of the LDPC code. When a code length is long, a check matrix H of the LDPC code is extremely large. Therefore, H is usually represented by blocks: A complete check matrix H is considered as being generated by a plurality of $Z_c \times Z_c$ submatrices. Specifically, the complete check matrix H may be represented by one base matrix $H_b$, each element in $H_b$ corresponds to one $Z_c \times Z_c$ submatrix, and each submatrix may be represented by a quantity of cyclic shift bits. Therefore, storage space needed by the complete check matrix H is greatly reduced. The element in the base matrix $H_b$ may also be referred to as a quasi-cyclic (quasi-cyclic, QC) block.

Based on the base matrix $H_b$ and the lifting value $Z_c$ (lifting size), the base matrix $H_b$ may be extended to a complete check matrix for encoding or decoding. $Z_c$ may also be referred to as an extension factor, a lifting factor, an extension value, an extension coefficient, a lifting size, or the like.

For example, the base matrix $H_b$ of the QC-LDPC code is shown as follows:

$$\begin{bmatrix} 13 & 48 & 80 & 66 & 4 & 74 & 7 & 30 & 76 & 52 & 37 & 60 & -1 & 49 & -1 & 73 & 31 & 74 & 73 & 23 & 1 & 0 & -1 & -1 \\ 69 & 63 & 74 & 56 & 64 & 77 & 57 & 65 & 6 & 16 & 51 & -1 & 64 & -1 & 64 & 68 & 9 & 48 & 62 & 54 & -1 & 0 & 0 & -1 \\ 51 & 15 & 0 & 80 & 24 & 25 & 42 & 54 & 44 & 71 & 71 & 9 & 67 & 35 & 67 & -1 & 58 & -1 & 29 & -1 & 0 & -1 & 0 & 0 \\ 16 & 29 & 36 & 41 & 44 & 56 & 59 & 37 & 50 & 24 & -1 & 65 & 4 & 65 & 4 & 52 & -1 & 4 & -1 & 73 & 1 & -1 & -1 & 0 \end{bmatrix}$$

It can be learned that a size of the base matrix $H_b$ is 4 rows and 24 columns, each element in the base matrix $H_b$ represents a $Z_c$-order square matrix, an element $P_{Z_c}^i$ represents a circulant permutation matrix, i represents a cyclic shift value, and i is an integer. In addition, in the base matrix $H_b$, "-1" represents an all-zero matrix, and "0" represents an identity matrix.

For example, $P_{Z_c}^1$ is shown as follows:

$$P_{Z_c}^1 = \begin{bmatrix} 0 & 1 & 0 & \dots & 0 \\ 0 & 0 & 1 & \dots & 0 \\ \vdots & \vdots & \vdots & \ddots & \vdots \\ 0 & 0 & 0 & \dots & 1 \\ 1 & 0 & 0 & \dots & 0 \end{bmatrix}$$

Optionally, in addition to "-1", a zero element in the base matrix $H_b$ may also be expressed in another form. For example, the all-zero matrix is represented by "-" or a null value. The base matrix of the LDPC code may also be referred to as an LDPC base matrix.

3. Non-zero element and zero element

In a check matrix, a zero element represents that there is no connection between a variable node and a check node, and a non-zero element represents that there is a connection between the variable node and the check node.

In an LDPC base matrix, a zero element represents a $Z_c$-order all-zero square matrix, a non-zero element represents a $Z_c$-order identity matrix or a circulant permutation matrix that is based on the $Z_c$-order identity matrix, and a value of the non-zero element represents a cyclic shift value or a shifting value (shifting value) relative to the identity matrix.

Specific representation forms of the zero element and the non-zero element are not limited in this application. For example, in the check matrix H shown in FIG. 2, a zero element is represented by "0", and a non-zero element is represented by "1". For another example, in the base matrix $H_b$ described above, a zero element is represented by "-1", and a non-zero element is represented by a "nonnegative value".

For ease of description, in the following LDPC base matrix, a zero element is represented by "0", and a non-zero element is represented by "1".

4. Column weight and row weight

For a column of a matrix, a column weight may be a quantity of non-zero elements included in the column. For a row of the matrix, a row weight may be a quantity of non-zero elements included in the row. For example, as shown in FIG. 2, in the check matrix H, a column weight of a $1^{st}$ column is 2, and a row weight of a $1^{st}$ row is 4. For another example, in the base matrix $H_b$ described above, a column weight of a $1^{st}$ column is 4, and a row weight of a $1^{st}$ row is 20.

5. Structure of a check matrix

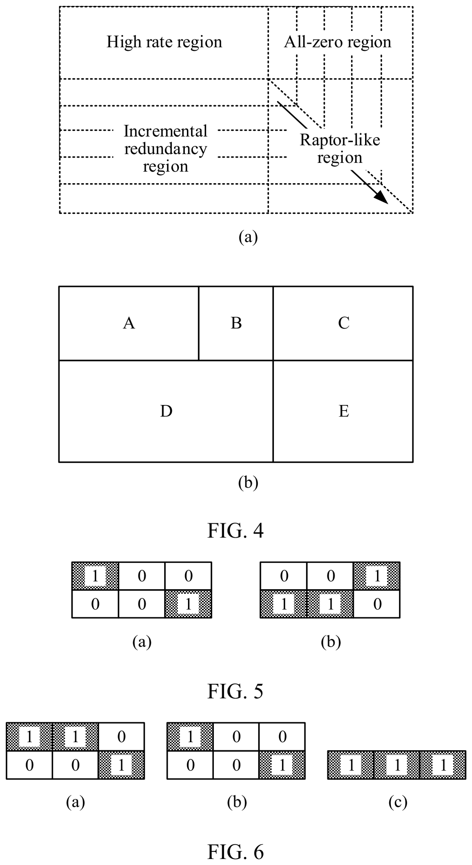

FIG. 4 is a diagram of a structure of a check matrix.
As shown in FIG. 4(a), the check matrix may include a high rate region (high rate region), an all-zero region, an incremental redundancy region (incremental redundancy region), and a raptor-like region (raptor-like region). The high rate region may include a part A and a part B shown in FIG. 4(b). The part A corresponds to an information bit (or referred to as an information bit, a system bit, or the like), and the part B is a square matrix and corresponds to a kernel check bit (or referred to as a kernel check bit). The all-zero region may correspond to a part C in FIG. 4(b), and is an all-zero matrix. The incremental redundancy region (incremental redundancy region) may correspond to a part D in FIG. 4(b). The raptor-like region may correspond to a part E in FIG. 4(b), may be an identity matrix, and corresponds to a check bit extended at a low code rate.
The check matrix of the LDPC code shown in FIG. 4 uses a "raptor-like" structure, and may be gradually extended to a low code rate through a kernel matrix with a high code rate. In actual use, as shown in FIG. 4(a), the first X rows and the first Y columns of the check matrix may be intercepted. As code rates are in descending order, X and Y gradually increase, and a region in which the matrix is used also gradually increases.
It should be noted that the check matrix may be represented by an LDPC base matrix. Therefore, a structure of the LDPC base matrix is similar to the structure of the check matrix, and details are not described herein again.

6. Kernel matrix, kernel row, kernel column, kernel part, and extension region

The kernel row is a row corresponding to the kernel check bit. In other words, the kernel row is a row corresponding to the high rate region.
The kernel column may include all information columns and all kernel check columns. In other words, the kernel column is a column corresponding to the high rate region, or a column corresponding to the part A and the part B.
The kernel matrix (Kernel Matrix) is a part including all kernel rows and all kernel columns of the LDPC check matrix or the LDPC base matrix. In other words, the kernel matrix is the high rate region of the LDPC check matrix or the LDPC base matrix, or a part including the part A and the part B.
The kernel part is a part including all rows and all of the kernel columns of the LDPC check matrix or the LDPC base matrix. In other words, the kernel part is a region including the high rate region and the raptor-like region, a region including the part A, the part B, and the part D, or a region corresponding to a non-raptor-like node.
The extension region may also be referred to as an extension matrix or an extension part, and may correspond to the incremental redundancy region or the part D described above.

7. Punctured column

The punctured column in the LDPC code may be a column that is not sent. The punctured column may be an information column, or may be a check column. In this application, an information column that is punctured is referred to as a punctured information column for short, and a check column that is punctured is referred to as a punctured check column for short.
In addition, a column that is not punctured in the LDPC code may also be referred to as a non-punctured column. Similarly, the non-punctured column may be an information column, or may be a check column. In this application, an information column that is not punctured is referred to as a non-punctured information column for short, and a check column that is not punctured is referred to as a non-punctured check column for short.

8. Column grouping

The column grouping means grouping columns of a matrix by using more than one column as a basic unit. For example, it is assumed that a kernel column set is C, and the kernel column set C is divided into t subsets $C_1$ to $C_t$. $C_1 \cup ... \cup C_t = C$, and an intersection set of any two of the t subsets is empty, that is, $C_i \cap C_j = \emptyset$, $C_i \neq \emptyset$, and $C_j \neq \emptyset$.
Uniform column grouping means that all of the t subsets include a same quantity of columns. Uniform k-column grouping is used as an example. For any subset $C_i$ in the t subsets, $|C_i| = k$.

Non-uniform column grouping means that there are at least two subsets in the t subsets, and the two subsets include different quantities of columns.

9. Row grouping

The row grouping means grouping rows of a matrix by using one or more rows as a basic unit. For example, it is assumed that a row set of the matrix is R, and the row set R is divided into s subsets $R_1$ to $R_s$. $R_1 \cup ... \cup R_s = R$, and an intersection set of any two of the s subsets is empty, that is, $R_i \cap R_j = \varnothing$, $R_i \neq \varnothing$, and $R_j \neq \varnothing$.

Uniform row grouping means that all of the s subsets include a same quantity of rows. Uniform q-row grouping is used as an example. For any subset $R_i$ in the s subsets, $|R_i| = q$.

Non-uniform row grouping means that there are at least two subsets in the s subsets, and the two subsets include different quantities of rows.

10. Group structure and basic group structure

The group structure may also be referred to as a group unit or a row-column division set. Any column set $C_j$ and any row set $R_i$ of a matrix meet the following condition: For any column $c \in C_j$, $|e(c, R_i)| \in \{0, 1\}$. In this case, a structure including a row included in $R_i$ and a column included in $C_j$ is referred to as a group structure, where $e(c, R_i)$ represents a set of edges between the column c and rows included in the row set $R_i$, and $|e(c, R_i)|$ represents a quantity of the edges between the column c and the rows included in the row set $R_i$. A column weight of each column of the group structure is less than or equal to 1.

Basic group structure: If $e(R_i, C_j) \neq \varnothing$ is true, a structure including a row included in $R_i$ and a column included in $C_j$ is referred to as a basic group structure.

In this application, the uniform k-column grouping and the uniform q-row grouping are used as an example for description. In this case, scales of group structures are consistent, and a quantity of edges included in the group structure is less than or equal to k.

11. Column-regular group structure

For the column set $C_j$ and the row set $R_i$, if for any $c_1, c_2 \in C_j$, $|e(c_1, R_i)| = |e(c_2, R_i)| \in \{0, 1\}$, $C_j$ and $R_i$ are referred to as a column-regular group structure, $|e(c_1, R_i)|$ represents a quantity of edges between the column $c_1$ and the rows included in the row set $R_i$, and $|e(c_2, R_i)|$ represents a quantity of edges between the column $c_2$ and the rows included in the row set $R_i$. In other words, column weights of all columns of the column-regular group structure are the same, and are all 0 or 1.

If for all j = 1, 2, ..., and t and i = 1, 2, ..., and q, $C_j$ and $R_i$ are a column-regular group structure, a group structure of the matrix is referred to as being column-regular.

FIG. 5 shows an example of a column-irregular group structure and a column-regular group structure. In a group structure shown in FIG. 5(a), a column weight of a 1st column is 1, a column weight of a 2nd column is 0, a column weight of a 3rd column is 1, and the column weights of the columns included in the group mechanism are different. Therefore, the group structure is a column-irregular group structure. In a group structure shown in FIG. 5(b), a column weight of each column is 1. Therefore, the group structure is a column-regular group structure.

12. Row-regular group structure

For the column set $C_j$ and the row set $R_i$, if for any $r_1, r_2 \in R_i$, $|e(r_1, C_j)| = |e(r_2, C_j)|$, $C_j$ and $R_i$ are referred to as a row-regular group structure, $|e(r_1, C_j)|$ represents a quantity of edges between the row $r_1$ and the rows included in the column set $C_j$, and $|e(r_2, C_j)|$ represents a quantity of edges between the row $r_2$ and the rows included in the column set $C_j$. In other words, row weights of all rows of the row-regular group structure are the same, and are all 0 or a value greater than or equal to 1.

If for all j = 1, 2, ..., and t and i = 1, 2, ..., and q, $C_j$ and $R_i$ are a row-regular group structure, a group structure of the matrix is referred to as being row-regular.

FIG. 6 shows an example of a row-irregular group structure and a row-regular group structure. In a group structure shown in FIG. 6(a), a column weight of a 1st row is 2, a column weight of a 2nd column is 1, and row weights of rows included in the group mechanism are different. Therefore, the group structure is a row-irregular group structure. In a group structure shown in FIG. 6(b), a column weight of each row is 1. Therefore, the group structure is a row-irregular group structure. A group structure shown in FIG. 6(c) includes only one row. Therefore, the group structure is a row-regular group structure.

13. Row-regular and column-regular group structure

If a group structure is row-regular and column-regular, a column weight of each column of the group structure is 0 or 1. Correspondingly, a row weight of each row of the group structure is 0 or k/q, and k is exactly divided by q.

The following provides two row-regular and column-regular group structures.

(1) Group structure 1: row-regular and column-regular group structure in which q=k

The group structure 1 is a square matrix, a column weight of each column of the group structure 1 is 1, and a row weight of each row is also 1.

In a possible implementation, q=k=2, 3, or 4.

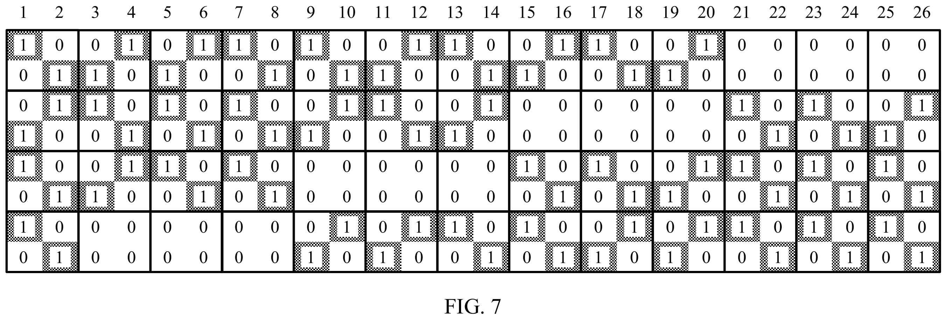

FIG. 7 is a diagram of a matrix using a group structure 1 in which k=2. As shown in FIG. 7, an $8\times26$ matrix is divided into $4\times13$ $2\times2$ group structures, and each group structure is row-regular and column-regular.

(2) Group structure 2: row-regular and column-regular group structure in which q=1

The group structure 2 includes only one row, a column weight of each column of the group structure 2 is 1, and a row weight is k.

In a possible implementation, k=2, 3, or 4.

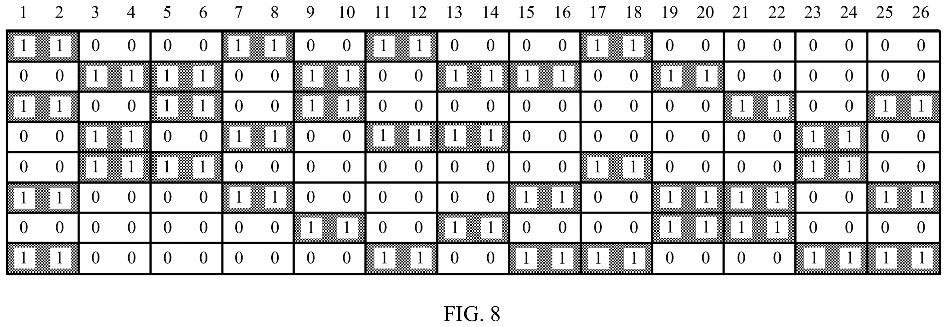

FIG. 8 is a diagram of a matrix using a group structure 2 in which k=2. As shown in FIG. 8, an $8\times26$ matrix is divided into $8\times13$ $1\times2$ group structures, and each group structure is row-regular and column-regular. Edges in each group structure are completely the same, that is, for any row r, $|N(r)\cap C_i|\in\{0, k\}$ is true. A row weight of the matrix is $k\times U$, where U is a quantity of group structures that are included in each row and whose column weights are 1.

Usually, a kernel matrix of an LDPC base matrix supports only the group structure 2.

14. Information transmission procedure

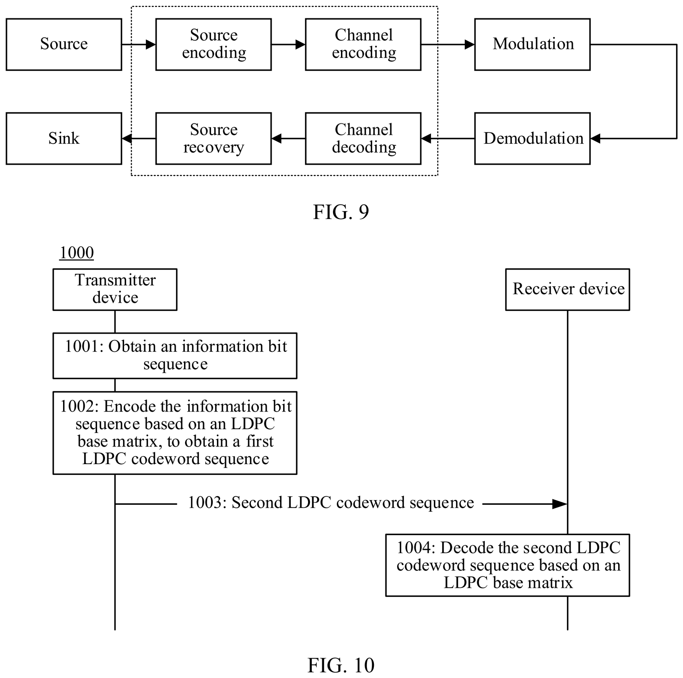

FIG. 9 is a diagram of an information transmission procedure. As shown in FIG. 9, information is sent by a source, and arrives at a sink after processing such as source encoding, channel encoding, modulation, air interface transmission, demodulation, channel decoding, and source recovery, to complete information transmission from the source to the sink. In FIG. 9, processing (including the source encoding, the channel encoding, the modulation, and the like) shown at an upper layer is performed at a transmitter device, and processing (including the demodulation, the channel decoding, the source recovery, and the like) shown at a lower layer is performed at a receiver device. Embodiments of this application mainly relate to the source encoding, the channel encoding, the channel decoding, and the source recovery shown in FIG. 9.

Currently, considering both a chip area and idle resources, a QC block parallel decoding architecture is used for a mainstream decoding architecture, and a chip is designed based on a codeword that supports using a maximum lifting value for decoding. For example, a lifting value supported by NR ranges from 2 to 384, and the chip is designed based on the maximum lifting value 384. However, in an actual decoding process, a used lifting value may be less than the maximum lifting value. In this case, hardware resources (for example, storage resources or computing resources) of the chip are idle, causing a waste of the hardware resources. In addition, when current hardware resources are greater than twice the used lifting value or in a high throughput scenario, a manner of parallel decoding of a plurality of QC blocks may be further used. However, an edge relationship of a current LDPC code is highly random. Even if the manner of parallel decoding of a plurality of QC blocks (for example, parallel decoding of two QC blocks) is used to double a decoding parallelism degree and occupied hardware resources, an actual throughput cannot be doubled.

For the foregoing problem, this application provides an LDPC code-based communication method and a communication apparatus, to improve decoding performance.

The following describes method embodiments of this application with reference to the accompanying drawings.

FIG. 10 is a schematic flowchart of an LDPC code-based communication method 1000 according to this application.

The method 1000 may be performed by a transmitter device and a receiver device. Unless otherwise specified, the "transmitter device" or the "receiver device" may be the transmitter device or the receiver device, or may be an apparatus that can support the transmitter device or the receiver device in implementing the function. For ease of description, the following uses the transmitter device and the receiver device for description. The transmitter device may be a terminal device or a network device, and the receiver device may be a terminal device or a network device.

The method 1000 may include at least a part of the following content.

Step 1001: The transmitter device obtains an information bit sequence.

In other words, if the transmitter device needs to communicate with the receiver device, in other words, the transmitter device needs to send a signal to the receiver device, the transmitter device needs to first obtain an information bit sequence corresponding to the signal that needs to be sent to the receiver device.

That the transmitter device obtains the information bit sequence may mean that the transmitter device performs source encoding on a source symbol to generate the information bit sequence. That the transmitter device obtains the information bit sequence may alternatively mean that the transmitter device receives the information bit sequence from another communication apparatus.

Step 1002: The transmitter device performs LDPC encoding on the information bit sequence based on an LDPC base matrix, to obtain a first LDPC codeword sequence.

A $(q \times (i-1)+1)^{th}$ row to a $(q \times i)^{th}$ row of a first part of the LDPC base matrix include $M_i$ first units, $F_i$ second units, and $G_i$ third units, the first part is a matrix region including a $1^{st}$ column to an $x^{th}$ column of the LDPC base matrix, $M_i$ is a positive integer, $F_i$ and $G_i$ are nonnegative integers, and x is an integer greater than or equal to 2. A "unit" herein may be a group structure mentioned in the term description part. For ease of understanding, the unit, the first unit, the second unit, and the third unit are respectively referred to as a group structure, a first group structure, a second group structure, and a third group structure below.

The first group structure, the second group structure, and the third group structure each are a matrix with q rows and k columns, and none of column weights of the columns of the matrix with the q rows and the k columns is greater than 1. Specifically, a column weight of each column of the first group structure is 1, that is, the first group structure is a column-regular group structure whose column weight is 1. A column weight of at least one column of the second group structure is 1, and a column weight of a remaining column is 0. Because the column weights of the columns of the second group structure are different, the second group structure is a column-irregular group structure. A column weight of each column of the third group structure is 0, that is, the third group structure is a column-regular group structure whose column weight is 0, or the third group structure is an all-zero matrix with q rows and k columns.

In this embodiment of this application, for different values of i, values of $M_i$, $F_i$, and $G_i$ may be the same or may be different. This is not limited. In a possible implementation, $F_i$ is a nonnegative integer less than or equal to a threshold $V_i$, and $V_i$ is a nonnegative integer. That $F_i$ is a nonnegative integer less than or equal to the threshold $V_i$ may be understood as that a quantity of column-irregular group structures included in the $(q \times (i-1)+1)^{th}$ row to the $(q \times i)^{th}$ row of the first part of the LDPC base matrix is less than a specific quantity.

In addition, for different values of i, sums of $M_i$, $F_i$, and $G_i$ may be the same or may be different. This is not limited. In a possible implementation, the sum of $M_i$, $F_i$, and $G_i$ is M. In other words, each q rows of the first part of the LDPC base matrix include M group structures whose sizes are $q \times k$, or each q rows of the first part of the LDPC base matrix are divided into M group structures whose sizes are $q \times k$.

When $F_i$ is not 0, the $(q \times (i-1)+1)^{th}$ row to the $(q \times i)^{th}$ row include a column-irregular group structure. In other words, group structures included in the $(q \times (i-1)+1)^{th}$ row to the $(q \times i)^{th}$ row include both a column-regular group structure and the column-irregular group structure. When $M_{i2}$ is 0, the $(q \times (i-1)+1)^{th}$ row to the $(q \times i)^{th}$ row include no column-irregular group structure. In other words, group structures included in the $(q \times (i-1)+1)^{th}$ row to the $(q \times i)^{th}$ row are all column-regular group structures.

It should be noted that structures and features of the LDPC base matrix mentioned in this embodiment of this application may be that the LDPC base matrix inherently has these structures and features, or may be that the LDPC base matrix has these features after experiencing row transformation and/or column transformation. This is not limited. For ease of description, the LDPC base matrix is used as an example for description in all embodiments of this application.

The structures and the features of the LDPC base matrix in this embodiment of this application are described in more detail below.

Step 1003: The transmitter device sends a second LDPC codeword sequence to the receiver device based on the first LDPC codeword sequence. In other words, the receiver device receives a second LDPC codeword sequence from the transmitter device.

Step 1004: The receiver device decodes the second LDPC codeword sequence based on an LDPC base matrix.

It should be noted that, because a channel noise signal may be introduced in a transmission process of the second LDPC codeword sequence, the second LDPC codeword sequence outputted or sent by the transmitter device may be different from the second LDPC codeword sequence received by the receiver device.

The LDPC base matrices used by the receiver device and the transmitter device may be the same or may be different. This is not limited. For example, the transmitter device and the receiver device both use an LDPC base matrix having a group structure. For another example, the transmitter device encodes the information bit sequence by using an LDPC base matrix that has a group structure after experiencing row transformation and/or column transformation, and the receiver device decodes the received second LDPC codeword sequence by using an LDPC base matrix that inherently has a group structure. For a feature of the LDPC base matrix used by the receiver device, refer to step 1003. Details are not described again.

Because none of the column weights of the columns of the first group structure, the second group structure, and the third group structure is greater than 1, the receiver device may perform parallel decoding of a plurality of QC blocks on a part that is in the second LDPC codeword sequence and that corresponds to the group structure. In other words, the receiver device may perform parallel decoding on a codeword sequence corresponding to each group structure.

In a possible implementation, the receiver device uses a same storage unit and computing unit to perform parallel decoding of a plurality of QC blocks on elements that are in the second LDPC codeword sequence and that correspond to those in the first group structure, the second group structure, or the third group structure. The storage unit and the computing unit herein are a storage unit and a computing unit of one QC block.

The following uses a minimum-sum (Min-Sum, MS) decoding algorithm as an example, and separately provides hardware decoding architectures corresponding to a group structure 1 and a group structure 2 when k=2, to provide a description that both the two group structures can be used for parallel decoding in an architecture in which decoding of k QC blocks are parallel. For the group structure 1 and the group structure 2, refer to the foregoing descriptions in FIG. 7 and FIG. 8.

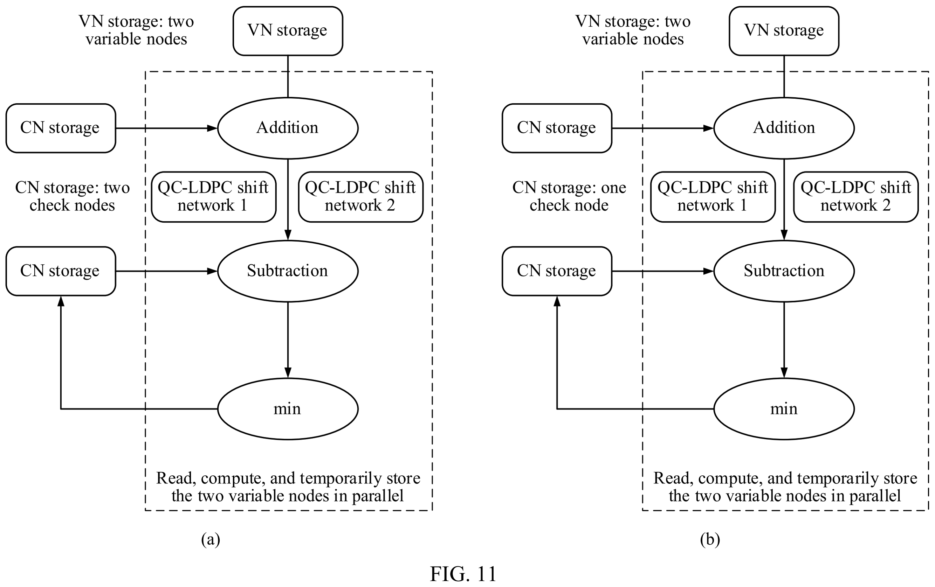

FIG. 11 is a diagram of hardware decoding architectures corresponding to a group structure 1 and a group structure 2.

FIG. 11(a) is a diagram of the hardware decoding architecture corresponding to the group structure 1. As shown in FIG. 11(a), variable nodes are stored based on a subset of a column group, in other words, two variable nodes in a subset are stored in a same storage unit (namely, a memory region); and check nodes are stored based on a subset of a row group, in other words, two check nodes in a subset are stored in a same storage unit. The two variable nodes are read into a computing unit at the same time, and computing and temporary storage of values corresponding to the two variable nodes are completed in the computing unit (for example, an addition unit, a subtraction unit, and a min unit in FIG. 11) at the same time. In this way, by using the group structure 1, the two variable nodes may be processed at one time, operation slots of the two variable nodes are completely consistent, and one variable node does not need to be processed after processing of the other variable node is completed. Therefore, a delay of processing the two variable nodes is consistent with a delay of processing one variable node separately.

FIG. 11(b) is a diagram of the hardware decoding architecture corresponding to the group structure 2. Different from the group structure 1, the decoding architecture processes one check node each time.

It can be learned from the hardware decoding architecture that group structures with a same scale are more conducive to hardware implementation. If the group structures use different scales, the hardware decoding architecture needs to be designed based on a group structure with a largest scale, including designs in terms of support for a quantity of variable nodes, support for a quantity of check nodes, support for a parallelism degree, and the like. In this case, for a group structure whose scale is less than the largest scale, hardware is wasted. If the group structures use a same scale, for example, $q \times k$, the hardware decoding architecture is designed based on the scale of $q \times k$. A hardware decoding architecture designed based on the scale of $q \times k$ supports decoding of q rows and k columns, and a decoding parallelism degree of the hardware decoding architecture is fixed (at most k). That the group structures included in the LDPC base matrix use the same scale may also be described as that the group structures included in the LDPC base matrix are uniform.

If group structures included in the LDPC base matrix are uniform and column-regular, a decoding parallelism degree is always k, and hardware resources (for example, parallelism degree resources) are not wasted. For example, a decoding parallelism degree of the first group structure in the foregoing M group structures is k, and the hardware resources are not wasted.

If group structures included in the LDPC base matrix are uniform and column-irregular, some hardware resources are wasted, and the wasted resources correspond to a quantity of columns whose column weights are 0 in a column-irregular group structure. For example, a decoding parallelism degree of the second group structure in the foregoing M group structures is a quantity of columns whose column weights are 1 in the second group structure. A column whose column weight is 0 causes a waste of hardware resources. In this case, for the second group structure, some hardware resources are wasted.

If group structures included in the LDPC base matrix are uniform, row-regular, and column-regular, the group structures included in the LDPC base matrix have regular structures, for example, the group structure 1 and the group structure 2. In this case, the hardware decoding architecture can be further simplified, and there is no waste of parallelism degree resources, computing resources, and the like.

Certainly, the LDPC base matrix in this embodiment of this application may alternatively use a non-uniform group structure. Using the non-uniform group structure is conducive to edge density matching of the LDPC base matrix and maintaining a parallelism degree of the computing resources, but increases design complexity of the hardware decoding architecture.

It can be learned from the foregoing content that the first group structure and the third group structure do not cause a waste of hardware resources, but the second group structure causes a waste of some hardware resources.

In the method 1000, none of the column weights of the columns of the first group structure, the second group structure, and the third group structure is greater than 1. Therefore, the receiver device may perform parallel decoding on a codeword sequence corresponding to each group structure, and a case in which decoding cannot be performed does not occur. This helps improve decoding performance. In addition, only the second group structure causes the waste of some hardware resources. Therefore, hardware utilization can be improved.

In addition, when the quantity of second group structures included in the $(q\times(i-1)+1)^{th}$ row to the $(q\times i)^{th}$ row of the first part of the LDPC base matrix is limited to be less than or equal to the threshold $V_i$, the quantity of second group structures included in the $(q\times(i-1)+1)^{th}$ row to the $(q\times i)^{th}$ row of the first part of the LDPC base matrix may be less than a specific quantity, that is, a quantity of column-irregular group structures included in the LDPC base matrix may be limited, to further improve hardware resource utilization.

An implementation in which the transmitter device sends the second LDPC codeword sequence based on the first LDPC codeword sequence is not limited in this embodiment of this application.

In a possible implementation, the first LDPC codeword sequence is the same as the second LDPC codeword sequence, that is, the transmitter device sends the LDPC codeword sequence obtained in step 1002 to the receiver device.

In another possible implementation, the transmitter device performs first interleaving between a part that is in the first LDPC codeword sequence and that corresponds to an information column of the LDPC base matrix and a part that is in the first LDPC codeword sequence and that corresponds to a kernel check column of the LDPC base matrix, to obtain the second LDPC codeword sequence. The transmitter device sends the second LDPC codeword sequence to the receiver device. The first interleaving is performed at a granularity of columns whose quantity is a lifting value, and a quantity of second group structures included in a base matrix corresponding to the second LDPC codeword sequence is less than a quantity of second group structures included in the base matrix corresponding to the first LDPC codeword sequence. The first interleaving is performed at the granularity of the columns whose quantity is the lifting value, that is, the first interleaving is interleaving performed between QC blocks at a granularity of a QC block. The interleaving performed between QC blocks at a granularity of a QC block may also be referred to as QC block-level interleaving for short.

For the foregoing implementation, that the receiver device decodes the second LDPC codeword sequence based on the LDPC base matrix may include: The receiver device performs first column transformation between the information column and the kernel check column of the LDPC base matrix, and decodes the second LDPC codeword sequence by using an LDPC base matrix obtained through the first column transformation. The first column transformation is performed at a granularity of columns whose quantity is the lifting value, a quantity of second group structures included in the LDPC base matrix obtained through the first column transformation is less than a quantity of second group structures included in the LDPC base matrix on which no first column transformation is performed, and the first column transformation performed by the receiver device corresponds to the first interleaving performed by the transmitter device. In other words, the receiver device does not perform de-interleaving on the second LDPC codeword sequence, but performs, on the LDPC base matrix, column transformation corresponding to interleaving performed by the transmitter device between QC blocks, and decodes the second LDPC codeword sequence by using an LDPC base matrix obtained through the column transformation. The first column transformation is performed at the granularity of the columns whose quantity is the lifting value, that is, the first column transformation is column transformation performed between QC blocks at a granularity of a QC block.

That the receiver device decodes the second LDPC codeword sequence based on the LDPC base matrix may alternatively include: The receiver device performs first de-interleaving on the second LDPC codeword sequence to obtain the first LDPC codeword sequence, and decodes the first LDPC codeword sequence based on the LDPC base matrix. A quantity of second group structures included in a base matrix corresponding to the first LDPC codeword sequence is less than a quantity of second group structures included in the base matrix corresponding to the second LDPC codeword sequence, and the first de-interleaving performed by the receiver device corresponds to interleaving performed by the transmitter device between QC blocks. The first de-interleaving is performed at a granularity of columns whose quantity is the lifting value, that is, the first de-interleaving is de-interleaving performed between QC blocks at a granularity of a QC block.

It should be noted that an application scenario of the interleaving between QC blocks is not limited in this embodiment of this application. For example, the interleaving between QC blocks may be applied to some specific scenarios. For example, in a high throughput scenario, an applied code rate is usually high, a code length is usually not long (less than 2048), and a part or all of a kernel matrix of the LDPC base matrix may be used for encoding and decoding. Therefore, the interleaving between QC blocks may be applied.

When the transmitter device performs the interleaving between QC blocks, optionally, the transmitter device may send indication information to the receiver device, to indicate the receiver device to perform, on the LDPC base matrix, corresponding column transformation between QC blocks or perform, on the second LDPC codeword sequence, corresponding de-interleaving between QC blocks.

The following describes in detail the interleaving performed by the transmitter device between QC blocks.

A quantity of information columns of the LDPC base matrix may not be exactly divided by a column group scale k, and the kernel check column of the LDPC base matrix needs a matrix structure that is easy to encode. Therefore, the LDPC base matrix inevitably has many column-irregular group structures, causing a waste of hardware resources. In this embodiment of this application, content of the interleaving between QC blocks is kernel columns, and an objective is to interleave the information column and the kernel check column in the kernel columns. The interleaving between QC blocks is performed between the information column and the kernel check column, to reduce the quantity of second group structures (or column-irregular group structures), so as to further reduce the waste of hardware resources. In addition, because the interleaving is performed at a granularity of a QC block, complexity is extremely low.

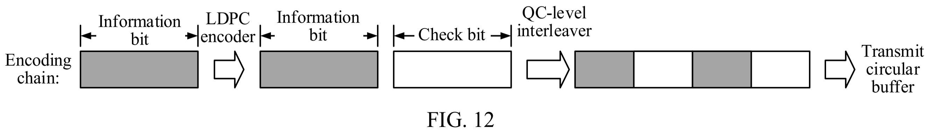

To implement the interleaving between QC blocks, an encoding chain (encoding chain) of the transmitter device may have a QC block-level interleaver. The QC block-level interleaver is different from an interleaver used for quadrature amplitude modulation (quadrature amplitude modulation, QAM) or fading (fading). A location of the QC block-level interleaver in the encoding chain is not limited in this embodiment of this application. For example, as shown in FIG. 12, the QC block-level interleaver may be before a transmit circular buffer. For another example, the QC block-level interleaver may be after the transmit circular buffer and before sending is read from the transmit circular buffer.

In a possible implementation, a principle of the interleaving between QC blocks is performing, between a codeword sequence corresponding to the information column of the LDPC base matrix and a codeword sequence corresponding to the kernel check column of the LDPC base matrix, interleaving between QC blocks at a granularity of a QC block, so that a symmetric difference between rows included in any two columns in a subset of each column group of an LDPC base matrix corresponding to an interleaved codeword sequence is less than or equal to 1. A row included in a column may be a row that has an edge with the column. The symmetric difference between the rows included in the two columns may alternatively be replaced with a symmetric difference between locations of non-zero elements in the two columns or a symmetric difference between non-zero elements in the two columns. The symmetric difference between the rows included in the two columns may be understood as a quantity of rows obtained by subtracting an intersection set of the rows included in the two columns from a union set of the rows included in the two columns.

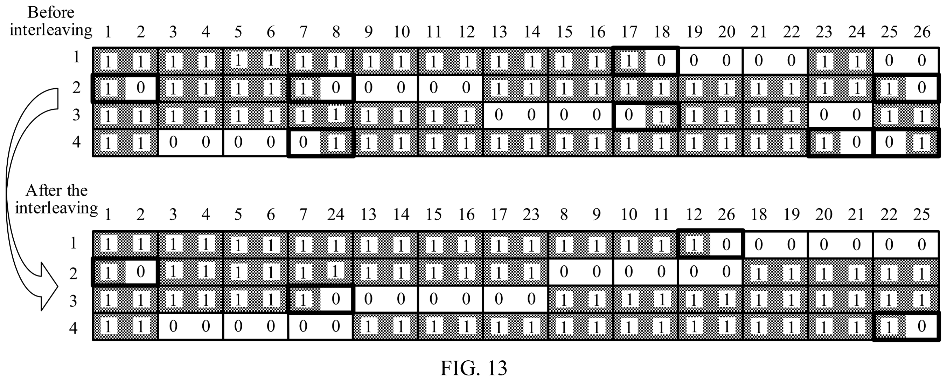

FIG. 13 is a diagram of interleaving between QC blocks that is performed between an information column and a kernel check column.

In FIG. 13, a group structure 2 in which k=2 is used as an example, and a black box in bold in the figure represents a column-irregular group structure. As shown in FIG. 13, before interleaving, rows included in a $7^{th}$ column and an $8^{th}$ column are {1, 2, 3} and {1, 3, 4} respectively, rows included in a $17^{th}$ column and an $18^{th}$ column are {1, 2, 4} and {2, 3, 4} respectively, rows included in a $25^{th}$ column and a $26^{th}$ column are {2, 3} and {3, 4} respectively, symmetric differences are all 2, and a matrix includes eight column-irregular group structures. After interleaving, a largest symmetric difference between rows included in two columns in each subset of a column group is 1, and a matrix includes four column-irregular group structures.

It should be noted that the interleaving between QC blocks may be implemented, as described above, in combination with the LDPC base matrix in step 1002, or may be separately implemented as an independent embodiment. When the interleaving between QC blocks is separately implemented, an LDPC base matrix used for encoding may not have the group structure in step 1002 in this application, but may have the group structure in step 1002 after the interleaving between QC blocks. A base matrix corresponding to an LDPC codeword sequence obtained through the interleaving between QC blocks may have a same group structure as the LDPC base matrix in step 1002.

The following describes in detail the structure and the feature of the LDPC base matrix in this embodiment of this application.

As described above, the first part of the LDPC base matrix in this embodiment of this application has a group structure. It should be noted that a region in which the group structure is used in the LDPC base matrix is not limited in this embodiment of this application.

In a possible implementation, the group structure is used in an entire kernel part of the LDPC base matrix. For descriptions of the kernel part, refer to the term description part. If a first region is the kernel part of the LDPC base matrix, the $1^{st}$ column to the $x^{th}$ column of the LDPC base matrix are all kernel columns of the LDPC base matrix, that is, the first part is a matrix region including all rows and all of the kernel columns of the LDPC base matrix.

In this case, the LDPC base matrix having a group structure may be represented by a smaller indicator matrix J. In other words, the LDPC base matrix may be obtained based on the indicator matrix J. One element in the indicator matrix J corresponds to one element in the first group structure, the second group structure, or the third group structure, and a value of the element in the indicator matrix J indicates locations/a location of a zero element and/or a non-zero element that are/is in the first group structure, the second group structure, or the third group structure and that correspond/corresponds to the element.

If the LDPC base matrix is divided into s×t group structures, the LDPC base matrix may be represented by an indicator matrix J with s rows and t columns, where s is a quantity of subsets in a row group, and t is a quantity of subsets in a column group.

For example, if an $i^{th}$ row and a $j^{th}$ column of the indicator matrix J are 0, it indicates that the location in the LDPC base matrix is a group structure whose size is q×k, and the group structure is a zero matrix; or if an $i^{th}$ row and a $j^{th}$ column of the indicator matrix J are 1, it indicates that the location in the LDPC base matrix is a group structure whose size is q×k, and a quantity of edges included in the group structure is not 0, in other words, the group structure is a basic group structure.

In a manner, storage of the LDPC base matrix may be storing the indicator matrix J, and an edge relationship of a group structure corresponding to a location whose value is 1 in the indicator matrix J is indicated, in other words, locations/a location of a zero element and/or a non-zero element in the group structure are/is indicated. For example, based on a type of a basic group structure, one value may be stored at each location whose value is 1 in the indicator matrix J, and the value indicates a type of a basic group structure at the location. The matrix shown in FIG. 7 is used as an example. The matrix includes two types of basic group structures. A type of a $1^{st}$ group structure of the matrix shown in FIG. 7 is a first type, and a type of a $2^{nd}$ group structure is a second type. If a zero matrix is represented by 0, a first type of basic group structure is represented by a value 1, and a second type of basic group structure is represented by 2, the matrix shown in FIG. 7 may be represented by the following indicator matrix J:

$$\begin{bmatrix} 1 & 2 & 2 & 1 & 1 & 2 & 1 & 2 & 1 & 2 & 0 & 0 & 0 \\ 2 & 1 & 1 & 1 & 2 & 1 & 2 & 0 & 0 & 0 & 1 & 1 & 2 \\ 1 & 2 & 1 & 1 & 0 & 0 & 0 & 1 & 1 & 2 & 1 & 1 & 1 \\ 1 & 0 & 0 & 0 & 2 & 2 & 1 & 1 & 2 & 2 & 1 & 1 & 1 \end{bmatrix}$$

In another manner, storage of the LDPC base matrix may alternatively be storing the LDPC base matrix, and the indicator matrix J does not need to be used for representation. The LDPC base matrix has a clear group structure.

In another possible implementation, the group structure may be used in a range in the kernel part of the LDPC base matrix.

In an example, the group structure may be used in a range of an $(n_1)^{th}$ column to an $(n_2)^{th}$ column and an $(m_1)^{th}$ row to an $(m_2)^{th}$ row of the LDPC base matrix.

In another example, the group structure may be used in a range in which a quantity of rows of the LDPC base matrix is greater than a row quantity threshold. In other words, row numbers of rows of the matrix region that is in the LDPC base matrix and that includes the first group structure, the second group structure, and the third group structure are all greater than a row number threshold. Because the kernel matrix has high edge density, a group structure that can be used generally needs to be limited to q=1. In other words, if the matrix region including the first group structure, the second group structure, and the third group structure includes the kernel matrix, a group structure that can be used generally needs to be limited to q=1. As a row number increases, edge density of the LDPC base matrix decreases. Therefore, if the group structure is used only in the range (for example, an extension region) in which a row number is greater than the row number threshold, compatibility with more types of group structures may be implemented, and the group structure is not limited to a group structure in which q=1. Therefore, the design is more flexible.

In another example, the group structure may be used in a range in which a quantity of rows of the LDPC base matrix is greater than a first row quantity threshold and less than a second row quantity threshold. In other words, row numbers of rows that belong to the first region in the LDPC base matrix are all greater than a first row number threshold and less than a second row number threshold. This design also has an advantage that the design is more flexible.

In another example, the group structure may be used in a range in which a code rate is greater than a second code rate threshold. In other words, row numbers of rows of the matrix region that is in the LDPC base matrix and that includes the first group structure, the second group structure, and the third group structure are all greater than a row number of a row of a matrix region corresponding to a first code rate, where the first code rate is greater than the second code rate threshold.

In this embodiment of this application, setting of a quantity $F_i$ of second group structures (that is, column-irregular group structures) included in a $(q \times (i-1)+1)^{th}$ row to a $(q \times i)^{th}$ row of the first region of the LDPC base matrix is not limited.

In a possible implementation, $F_i$ is related to at least one of the following information: code rates corresponding to the $(q \times (i-1)+1)^{th}$ row to the $(q \times i)^{th}$ row, row weights of the $(q \times (i-1)+1)^{th}$ row to the $(q \times i)^{th}$ row, or edge relationships of the $(q \times (i-1)+1)^{th}$ row to the $(q \times i)^{th}$ row of a punctured column of the LDPC base matrix.

For example, on the whole, $F_i$ decreases as the code rate decreases. In a manner, as the code rate decreases, $F_i$ may decrease by segment. For example, when the code rate is greater than, less than, or equal to a first code rate threshold, $F_i$ is greater than 0; or when the code rate is greater than a first code rate threshold, $F_i$ is 0.

For example, on the whole, $F_i$ decreases as the row weight decreases. In a manner, for example, as the row weight decreases, $F_i$ may decrease by segment. For example, when the row weight is less than or equal to a row weight threshold, $F_i$ is greater than 0; or when the row weight is greater than a row weight threshold, $F_i$ is 0.

For example, as the code rate decreases, $F_i$ may decrease by segment, and is inversely proportional to a quantity of non-zero elements outside the punctured column.

For example, as the code rate decreases, $F_i$ may decrease by segment, and is directly proportional to a quantity of zero elements outside the punctured column.

The row weights of the $(q \times (i-1)+1)^{th}$ row to the $(q \times i)^{th}$ row include at least one of the following information: row weights of the $(q \times (i-1)+1)^{th}$ row to the $(q \times i)^{th}$ row in which a punctured column included in the LDPC base matrix is included; row weights of the $(q \times (i-1)+1)^{th}$ row to the $(q \times i)^{th}$ row in which a punctured column included in the LDPC base matrix is not included; or row weights of the $(q \times (i-1)+1)^{th}$ row to the $(q \times i)^{th}$ row when the LDPC base matrix includes no punctured column.

An example in which the LDPC base matrix includes punctured columns 1 and 2, and q=1 is used to describe edge relationships of the $(q \times (i-1)+1)^{th}$ row to the $(q \times i)^{th}$ row of the punctured columns of the LDPC base matrix. The edge relationship may be as follows: The row has an edge with each of the punctured columns 1 and 2; the row has an edge with the punctured column 1 but has no edge with the punctured column 2; the row has no edge with the punctured column 1 but has an edge with the punctured column 2; or the row has an edge with neither of the punctured columns 1 and 2.

In another possible implementation, in this embodiment of this application, $F_i$ may gradually decrease as i increases. For example, when $i_1$ is less than $i_2$, $F_{i_1}$ is greater than $F_{i_2}$, where $F_{i_1}$ is a value of $F_i$ when $i=i_1$, and $F_{i_2}$ is a value of $F_i$ when $i=i_2$.

In an example, that $F_i$ decreases as i increases may mean that a value range of i includes a plurality of consecutive subranges, same subranges correspond to same $F_i$, and $F_i$ decreases in order of the subranges. In other words, quantities of column-irregular group structures are segmented as i changes, and the quantity of column-irregular group structures decreases in order of segments. Optionally, each segment corresponds to a same quantity of column-irregular group structures. If the plurality of consecutive subranges have numbers, that $F_i$ decreases in order of the subranges may be understood as that $F_i$ decreases in ascending order of the subrange numbers.

For example, when i is less than a first value (that is, a subrange 1), $F_i$ is greater than 0; or when i is greater than or equal to a first value (that is, a subrange 2), $F_i$ is 0. In other words, it may be designed that the quantity of column-irregular group structures is 0 after i exceeds the first value.

For another example, when i is less than a second value (that is, a subrange 1), $F_i$ is 2; when i is greater than or equal to a second value and less than a third value (that is, a subrange 2), $F_i$ is 1; or when i is greater than or equal to a third value (that is, a subrange 3), $F_i$ is 0.

In this embodiment of this application, q=1 (corresponding to the foregoing group structure 2) may be set, or q=k (corresponding to the foregoing group structure 1) may be set. The following separately describes LDPC base matrix designs in the two cases.

Case 1: q=1, that is, the group structure includes one row.

In this case, the LDPC base matrix is designed in a plurality of manners. This is not limited.

In a first possible implementation, the first part includes a third subpart, the third subpart is a matrix region including a $1^{st}$ row to a $u^{th}$ row and a $1^{st}$ column to an $x^{th}$ column of the first part, and u is an integer greater than or equal to 1. For example, the third subpart is a kernel matrix of the LDPC base matrix, columns of the kernel matrix may belong to a plurality of groups, a symmetric difference between rows included in any two columns in each group is 0 or 1, and each group includes at most one second group structure (namely, a column-irregular group structure).

The group herein may be a group obtained by classifying kernel columns by using "included rows" as a classification basis. Because the kernel matrix has a small quantity of rows, the kernel columns may be classified by using the rows included in the columns. A row included in a column may be a row that has an edge with the column. For example, it is assumed that a row set corresponding to the kernel matrix is $\gamma=\{r_1, r_2, ..., r_X\}$, a set of rows included in each kernel column is $\delta$, and $\delta \subseteq \gamma$. The kernel columns are classified based on $\delta$ of each kernel column, to obtain a plurality of groups. A symmetric difference between rows included in any two columns in each group is less than or equal to 1. Optionally, $\delta$ of rows in each group satisfies $|\delta|=X$ or $|\delta|=X-1$, where $|\delta|$ represents a quantity of rows in the row set $\delta$, and X is a quantity of rows included in the kernel matrix.

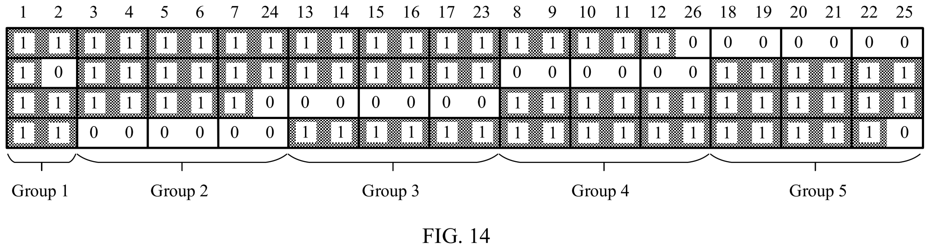

FIG. 14 shows an example of grouping kernel columns. In FIG. 14, k=2 is used as an example. As shown in FIG. 14, after column transformation, 26 kernel columns may be grouped into a group 1 to a group 5. The group 1 includes a $1^{st}$ column and a $2^{nd}$ column, the group 2 includes the $1^{st}$ column to a $7^{th}$ column and a $24^{th}$ column, the group 3 includes a $12^{th}$ column to a $17^{th}$ column and a $23^{rd}$ column, the group 4 includes an $8^{th}$ column to a $12^{th}$ column and a $26^{th}$ column, and the group 5 includes an $18^{th}$ column to a $22^{nd}$ column and a $25^{th}$ column. The groups 1, 2, 4, and 5 each include a column-irregular group structure, and the group 3 includes no column-irregular group structure.

A manner of classifying the kernel columns based on the "included rows" is applicable to an LDPC base matrix including a punctured column, or applicable to an LDPC base matrix including no punctured column. This is not limited.

When the LDPC base matrix includes the punctured column, the kernel matrix definitely includes a column-irregular group structure. In a possible implementation, a group including the punctured column definitely includes a column-irregular group structure. Optionally, at most one of the $F_2$ second group structures included in the $(q \times (i-1)+1)^{th}$ row to the $(q \times i)^{th}$ row of the first part of the LDPC base matrix includes the punctured column. When the LDPC base matrix may be represented by the indicator matrix J, that the at most one of the $F_2$ second group structures included in the $(q \times (i-1)+1)^{th}$ row to the $(q \times i)^{th}$ row of the first part of the LDPC base matrix includes the punctured column may also be described as that each row of the indicator matrix J corresponds to at most one column-irregular group structure including the punctured column. A matrix region corresponding to a non-punctured information column of the LDPC base matrix includes no second group structure.

In addition, when the kernel matrix includes the column-irregular group structure, a matrix range to which the group structure is applicable is all of the kernel matrix, that is, the column-irregular group structure may be compatible with a matrix region including a kernel check column and a kernel row.

When the LDPC base matrix includes no punctured column, the kernel matrix may include a column-irregular group structure, or may not include a column-irregular group structure. This is not limited.

In a second possible implementation, the first part includes a second subpart and a first subpart. The second subpart is a matrix region including a $1^{st}$ row to a $u^{th}$ row and a $1^{st}$ column to a $y^{th}$ column of the first part, the first subpart is a matrix region including the $1^{st}$ row to the $u^{th}$ row and a $(y+1)^{th}$ column to an $x^{th}$ column of the first part, u is an integer greater than or equal to 1, $u-1=x-y-1$, and y is less than x. For example, the second subpart is a matrix region including all kernel rows of the LDPC base matrix and all information columns of the LDPC base matrix, that is, a part A. The first subpart is a matrix region including all of the kernel rows of the LDPC base matrix and all kernel check columns of the LDPC base matrix, that is, a part B.

The columns of the second subpart belong to a plurality of groups, and a symmetric difference between rows included in any two columns in each group is 0 or 1. Each group includes at most one column-irregular group structure, or the second subpart includes no column-irregular group structure, where a matrix region corresponding to a non-punctured information column includes no second group structure. For a manner of obtaining the plurality of groups, refer to the first possible implementation. Details are not described again.

Diagonal elements in the first subpart are all non-zero elements, the first subpart includes N blocks, and the N blocks include all of the diagonal elements in the first subpart. Each of the N blocks is a square matrix, a diagonal element in each block overlaps the diagonal element in the first subpart, and the blocks do not overlap. A part or all of the N blocks include a plurality of rows, and non-zero elements in at least two of the plurality of rows included in the blocks have a proper inclusion relationship. That the two rows have the proper inclusion relationship may be understood as that a column included in one of the two rows is properly included in a column included in the other of the two rows. A column included in a row may be a column that has an edge with the row. For example, if a row #1 includes a column #1, a column #2, and a column #3, and a row #2 includes the column #2 and the column #3, the row #2 is properly included in the row #1.

In a possible implementation, the N blocks include N1 first blocks and one second block, a size of the first block is $k \times k$, a size of the second block is $k' \times k'$, N1 is a positive integer, N2 is a nonnegative integer, and k' is less than k.

In a possible implementation, an element other than the N blocks in the first subpart may include a non-zero element, or each may be a zero element. When each element other than the N blocks in the first subpart is the zero element, the first subpart has a smallest quantity of non-zero elements. This helps reduce hardware complexity.

The following describes a design of the first subpart (that is, the part B) in detail.

The part B of the LDPC base matrix is a kernel check region and is a square matrix. It is assumed that the part B is an $X \times X$ square matrix, where X is a quantity of kernel rows, that is, $u-1=x-y-1=X$. A design principle of the part B of the matrix is that it is easy to perform encoding by solving an equation and the base matrix is full-rank. Because the column group scale k may not be exactly divided by X, column groups may be non-uniform column groups. If the column groups of the part B are non-uniform column groups, a quantity of columns included in at most one of subsets of the column groups corresponding to the part B is less than k, that is, the column groups of the part B are $C_1$, $C_2$, ..., and $C_r$, $|C_i|=k$ is true for i<r, $|C_r|=k'$, and $k' \leq k$.

First, the part B is divided into blocks. For i<r and j<r, a range of a block (i, j) is a matrix region including an $((i-1)*k+1)^{th}$ row to an $(i*k)^{th}$ row and a $((j-1)*k+1)^{th}$ column to a $(j*k)^{th}$ column. For i=r and j<r, a range of a block (i, j) is a matrix region including an $((r-1)*k+1)^{th}$ row to an $X^{th}$ row and a $((j-1)*k+1)^{th}$ column to a $(j*k)^{th}$ column. For i<r and j=r, a range of a block (i, j) is a matrix region including an $((i-1)*k+1)^{th}$ row to an $(i*k)^{th}$ row and an $((r-1)*k+1)^{th}$ column to an $X^{th}$ column. For i=r and j=r, a range of a block (i, j) is a matrix region including an $((r-1)*k+1)^{th}$ row to an $X^{th}$ row and an $((r-1)*k+1)^{th}$ column to an $X^{th}$ column.

Then, the blocks obtained through division are classified to obtain two types of blocks. A first type is a block in which i=j, and a second type is all remaining blocks. The N blocks in the third matrix are first-type blocks.

The first-type block includes all of the diagonal elements in the part B, and a group structure included in the first-type block is definitely a non-all-zero group structure (or a basic group structure). If the LDPC base matrix is represented by the indicator matrix J, a location that is in the indicator matrix J and that corresponds to the first-type block is definitely a non-zero element. For example, it is assumed that rows included in a block L in the first-type block are divided into $R_1$, $R_2$, ..., and $R_f$. In this case, $e(R_x, C_i) \neq \emptyset$ is true for x=1, ..., f. If the group structure 2 is used, $|R_x|=q=1$, and the block L includes k group structures (for i<r, the block L includes k rows) or k' group structures (for i=r, the block L includes k' rows).

A group structure included in the second-type block may be an all-zero group structure, or may be a non-all-zero group structure. If the LDPC base matrix is represented by the indicator matrix J, a location that is in the indicator matrix J and that corresponds to the second-type block may be a zero element. In a possible implementation, group structures included in the second-type block are all all-zero group structures, that is, there is no edge in a region of the second-type block, and all edges are in the first-type block. In this case, the part B has a smallest quantity of non-zero elements, and hardware complexity is the lowest.

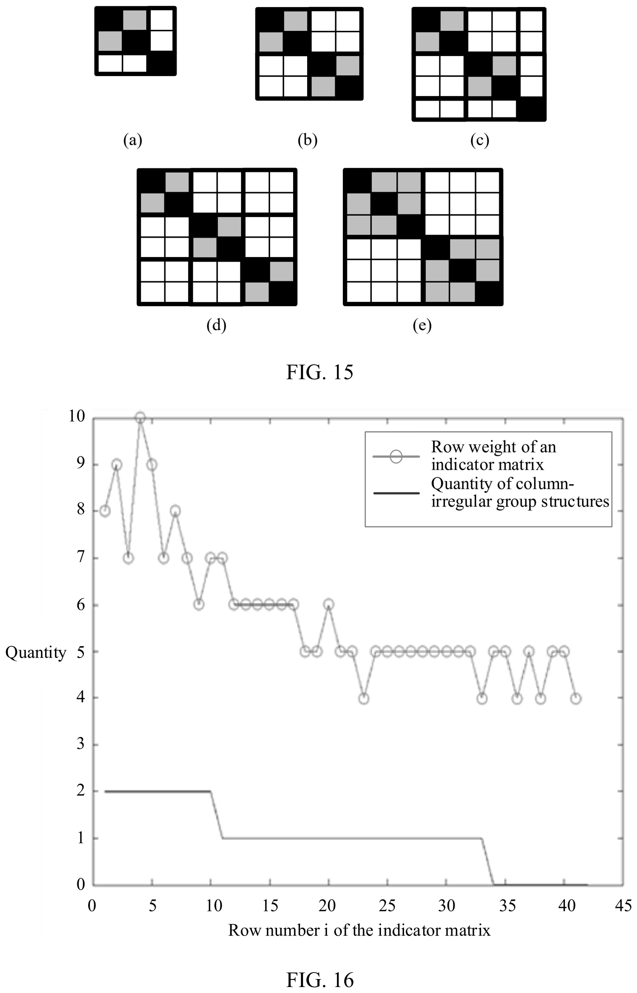

FIG. 15 is a diagram of dividing a part B into blocks.

A region of a black box in bold in FIG. 15 represents a block, a block including a black square and a gray square is a first-type block, and a block including a white square is a second-type block. A location of the black square has an edge, a location of the gray square may have an edge, and a location of the white square has no edge.

FIG. 15(a) is a diagram of blocks included in a part B when k=2 and X=3. In this case, a first-type block in the part B includes one 2×2 block and one 1×1 block, and a second-type block includes one 1×2 block and one 2×1 block. FIG. 15(b) is a diagram of blocks included in a part B when k=2 and X=4. In this case, a first-type block in the part B includes two 2×2 blocks, and a second-type block includes two 2×2 blocks. FIG. 15(c) is a diagram of blocks included in a part B when k=2 and X=5. In this case, a first-type block in the part B includes two 2×2 blocks and one 1×1 block, and a second-type block includes two 2×2 blocks, two 2×1 blocks, and two 1×2 blocks. FIG. 15(d) is a diagram of blocks included in a part B when k=2 and X=6. In this case, a first-type block in the part B includes three 2×2 blocks, and a second-type block includes six 2×2 blocks. FIG. 15(e) is a diagram of blocks included in a part B when k=3 and X=6. In this case, a first-type block in the part B includes two 3×3 blocks, and a second-type block includes two 3×3 blocks.

After locations of the blocks are determined, locations of non-all-zero group structures are determined. A more detailed feature of the non-all-zero group structure is described below.

Because the first-type block includes all of the diagonal elements in the part B, a column-irregular group structure definitely exists in k or k' non-all-zero group structures (when q=1) included in each first-type block, and non-zero elements (or edges) in at least two of a plurality of rows included in the block have a proper inclusion relationship. For example, it is assumed that a row corresponding to the column-irregular group structure is $R_1$. If there is a column-regular group structure, and it is assumed that a row corresponding to the column-regular group structure is $R_2$, $e(R_1, C_i)$ is properly included in $e(R_2, C_i)$. If there is no column-regular group structure, the foregoing proper inclusion relationship also definitely exists. An advantage of not requiring the column-regular group structure to definitely exist in the block is that degree distribution is more flexible and design space is larger.

In a possible implementation, each block in which i=j=1, ..., r-1 has a column-regular group structure and a column-irregular group structure. Based on a block scale, a block in which i=j=r may have only a column-irregular group structure, have only a column-regular group structure, or have both a column-irregular group structure and a column-regular group structure. If a quantity of rows of the block in which i=j=r is greater than 1, non-zero elements (or edges) in at least two of the plurality of rows of the block have a proper inclusion relationship.

An advantage of the foregoing implementation of the part B is that encoding is easy, and an equation can be solved by accumulating kernel check equations, to achieve an encoding effect. In addition, a structure of part B is not a dual-diagonal structure. An encoding process of the part B according to this embodiment of this application may be performed by using a block as a basic structure, that is, performed on each block in which i=j sequentially or in parallel, where i=j=1, 2, ..., r.

The following provides several examples of the part B.

When u-1=x-y-1=X=3 and k=2, locations of zero elements and non-zero elements in the part B are shown in either of the following matrices:

$$\begin{bmatrix} 1 & 1 & 0 \\ 0 & 1 & 0 \\ 0 & 0 & 1 \end{bmatrix} \text{ or } \begin{bmatrix} 1 & 0 & 0 \\ 1 & 1 & 0 \\ 0 & 0 & 1 \end{bmatrix}.$$

When u-1=x-y-1=X=3 and k=3, locations of zero elements and non-zero elements in the part B are shown in the following matrix:

$$\begin{bmatrix} 1 & 1 & 1 \\ 0 & 1 & 0 \\ 0 & 0 & 1 \end{bmatrix}.$$

When u-1=x-y-1=X=4 and k=2, locations of zero elements and non-zero elements in the part B are shown in any one of the following matrices:

$$\begin{bmatrix} 1 & 1 & 0 & 0 \\ 0 & 1 & 0 & 0 \\ 0 & 0 & 1 & 1 \\ 0 & 0 & 0 & 1 \end{bmatrix}, \begin{bmatrix} 1 & 1 & 0 & 0 \\ 0 & 1 & 0 & 0 \\ 0 & 0 & 1 & 0 \\ 0 & 0 & 1 & 1 \end{bmatrix}, \text{ or } \begin{bmatrix} 0 & 0 & 1 & 1 \\ 0 & 0 & 1 & 0 \\ 1 & 1 & 0 & 0 \\ 1 & 0 & 0 & 0 \end{bmatrix}.$$

When u-1=x-y-1=X=4 and k=3, locations of zero elements and non-zero elements in the part B are shown in either of the following matrices:

$$\begin{bmatrix} 1 & 1 & 1 & 0 \\ 0 & 1 & 1 & 0 \\ 0 & 0 & 1 & 0 \\ 0 & 0 & 0 & 1 \end{bmatrix}, \begin{bmatrix} 1 & 1 & 0 & 0 \\ 0 & 1 & 1 & 0 \\ 0 & 0 & 1 & 0 \\ 0 & 0 & 0 & 1 \end{bmatrix}.$$

When u-1=x-y-1=X=5 and k=2, locations of zero elements and non-zero elements in the part B may be shown in the following matrix:

$$\begin{bmatrix} 1 & 1 & 0 & 0 & 0 \\ 0 & 1 & 0 & 0 & 0 \\ 0 & 0 & 1 & 1 & 0 \\ 0 & 0 & 0 & 1 & 0 \\ 0 & 0 & 0 & 0 & 1 \end{bmatrix}.$$

When u-1=x-y-1=X=5 and k=3, locations of zero elements and non-zero elements in the part B may be shown in the following matrix:

$$\begin{bmatrix} 1 & 1 & 1 & 0 & 0 \\ 0 & 1 & 1 & 0 & 0 \\ 0 & 0 & 1 & 0 & 0 \\ 0 & 0 & 0 & 1 & 1 \\ 0 & 0 & 0 & 0 & 1 \end{bmatrix}.$$

When u-1=x-y-1=X=5 and k=4, locations of zero elements and non-zero elements in the part B may be shown in the following matrix:

$$\begin{bmatrix} 1 & 1 & 1 & 1 & 0 \\ 0 & 1 & 1 & 1 & 0 \\ 0 & 0 & 1 & 1 & 0 \\ 0 & 0 & 0 & 1 & 0 \\ 0 & 0 & 0 & 0 & 1 \end{bmatrix}.$$

When u-1=x-y-1=X=5 and k=5, locations of zero elements and non-zero elements in the part B may be shown in the following matrix:

$$\begin{bmatrix} 1 & 1 & 1 & 0 & 1 \\ 0 & 1 & 1 & 0 & 1 \\ 0 & 0 & 1 & 1 & 1 \\ 0 & 0 & 0 & 1 & 1 \\ 0 & 0 & 0 & 0 & 1 \end{bmatrix}.$$

When u-1=x-y-1=X=6 and k=2, locations of zero elements and non-zero elements in the part B may be shown in the following matrix:

$$\begin{bmatrix} 1 & 1 & 0 & 0 & 0 & 0 \\ 0 & 1 & 0 & 0 & 0 & 0 \\ 0 & 0 & 1 & 1 & 0 & 0 \\ 0 & 0 & 0 & 1 & 0 & 0 \\ 0 & 0 & 0 & 0 & 1 & 1 \\ 0 & 0 & 0 & 0 & 0 & 1 \end{bmatrix}.$$

When u-1=x-y-1=X=6 and k=3, locations of zero elements and non-zero elements in the part B may be shown in the following matrix:

$$\begin{bmatrix} 1 & 1 & 1 & 0 & 0 & 0 \\ 0 & 1 & 1 & 0 & 0 & 0 \\ 0 & 0 & 1 & 0 & 0 & 0 \\ 0 & 0 & 0 & 1 & 1 & 1 \\ 0 & 0 & 0 & 0 & 1 & 1 \\ 0 & 0 & 0 & 0 & 0 & 1 \end{bmatrix}.$$

It should be noted that the examples of the part B are merely for ease of understanding, and do not mean that the part B is limited thereto.

The foregoing describes the design of the kernel matrix of the LDPC base matrix in Case 1. In some possible implementations, the first part further includes a fourth subpart, and the fourth subpart may be an extension matrix of the LDPC base matrix. The following describes a design of the extension matrix.

A quantity of column-irregular group structures included in the extension matrix is less than a quantity of column-irregular group structures included in the kernel matrix, and as a code rate decreases, the quantity of column-irregular group structures gradually decreases.

FIG. 16 is a line graph of a quantity change of column-irregular group structures at different code rates.

As a row number i of the indicator matrix J increases, the code rate gradually decreases. As i increases, an overall row weight of the indicator matrix J presents a decrease trend, and the quantity of column-irregular group structures also presents a decrease trend. A quantity of column-irregular group structures (that is, second group structures) corresponding to each i may be a quantity of column-irregular group structures included in the $(q\times(i-1)+1)^{th}$ row to the $(q\times i)^{th}$ row of a non-punctured information column in the $1^{st}$ column to the $x^{th}$ column of the LDPC base matrix, may be a quantity of column-irregular group structures included in the $(q\times(i-1)+1)^{th}$ row to the $(q\times i)^{th}$ row of an information column in the $1^{st}$ column to the $x^{th}$ column of the LDPC base matrix, or may be a quantity of column-irregular group structures included in the $(q\times(i-1)+1)^{th}$ row to the $(q\times i)^{th}$ row of a non-punctured column in the $1^{st}$ column to the $x^{th}$ column of the LDPC base matrix.

A change of a quantity of column-irregular group structures of the extension region with the row number i of the indicator matrix J may be the same as the foregoing relationship between $F_i$ and i. Details are not described herein again.

In a possible implementation, a sum of shifting values of non-zero elements of the first group structure in Case 1 is an integer multiple of the lifting value.

In a possible implementation, in Case 1, when the code rate is greater than the first code rate threshold, $F_i$ is 0. For example, the first code rate threshold is any one of the following code rates: 0.926, $\frac{22}{24}$, $\frac{22}{25}$, or $\frac{22}{26}$ .

Case 2: q=k, that is, the group structure is a square matrix, and a quantity of included rows and a quantity of included columns are greater than or equal to 2.

In Case 2, if the group structure is column-regular and row-regular (a row weight of each row of the group structure is 1 and a column weight of each column is 1), that is, the first group structure, each group structure may be considered as being generated through "lifting", and a "lifting" manner is not limited to a quasi-cyclic lifting manner. The following provides two construction manners of the group structure in Case 2.

Manner 1: The "lifting" may be represented by permutation of a sequence θ $(\theta_1, \theta_2, ..., \theta_a, ..., \theta_k)$ whose length is k. In other words, each column-regular and row-regular group structure may be obtained through the permutation of the sequence θ $(\theta_1, \theta_2, ..., \theta_a, ..., \theta_k)$ whose length is k. The $a^{th}$ element $\theta_a$ of θ represents that an $a^{th}$ row and a $(\theta_a)^{th}$ column of the group structure have an edge (or an element at the location is a non-zero element), and a is an integer greater than 0 and less than or equal to k.

A construction manner of $\theta_a$ is not limited in this embodiment of this application.

In a possible implementation, $\theta_a$=a+b(mod k), or $\theta_a$=k+1-a+b(mod k), where b is a constant.

A manner of setting shifting values of non-zero elements of the first group structure is not limited in this embodiment of this application.

In a possible implementation, shifting values of all of the non-zero elements of the first group structure are the same.

In another possible implementation, remainders of any two non-zero elements of the first group structure relative to the lifting value are the same.

In another possible implementation, a sum of shifting values of all of the non-zero elements of the first group structure is an integer multiple of the lifting value.

The permutation in Manner 1 is circulant permutation of θ $(\theta_1, \theta_2, ..., \theta_a, ..., \theta_k)$ as a whole.

Manner 2: Each column-regular and row-regular group structure may include K segments, the K segments are divided by column, an intersection set of any two of the K segments is empty, a union set of the K segments is the group structure, K is greater than or equal to 2, and a $c^{th}$ segment of the K segments is obtained through permutation of a sequence $\theta^c$ ( $\theta_1^c$, $\theta_2^c$, ..., $\theta_a^c$, ..., $\theta_{K^c}^c$ ) whose length is |K$^c$|, where the a$^{th}$ element $\theta_a^c$ of $\theta^c$ represents that an element in an a$^{th}$ row and a $(\theta_a^c)^{th}$ column of the c$^{th}$ segment is a non-zero element, |K$^c$| is a quantity of columns of the c$^{th}$ segment, c is an integer greater than 0 and less than or equal to K, and a is an integer greater than 0 and less than or equal to K$^c$.

A construction manner of $\theta_a^c$ is not limited in this embodiment of this application.

In a possible implementation, $\theta_a^c = a + b^c (\bmod |K^c|)$, or $\theta_a^c = |K^c| + 1 - a + b^c (\bmod |K^c|)$, where b$^c$ is a constant corresponding to the c$^{th}$ segment.

A manner of setting shifting values of non-zero elements of each segment is not limited in this embodiment of this application.

In a possible implementation, shifting values of all non-zero elements of the c$^{th}$ segment are the same.

In another possible implementation, remainders of any two non-zero elements of the c$^{th}$ segment relative to the lifting value are the same.

In another possible implementation, a sum of shifting values of all non-zero elements of the c$^{th}$ segment is an integer multiple of the lifting value.

The permutation in Manner 2 is permutation in which each segment is a cycle but the whole may not be a cycle.

The following provides several examples of the first group structure.

When q=k=2, locations of zero elements and the non-zero elements of the first group structure are shown in either of the following matrices:

$$\begin{bmatrix} 1 & 0 \\ 0 & 1 \end{bmatrix} \text{ or } \begin{bmatrix} 0 & 1 \\ 1 & 0 \end{bmatrix}.$$

When q=k=3, locations of zero elements and the non-zero elements of the first group structure are shown in any one of the following matrices:

$$\begin{bmatrix} 1 & 0 & 0 \\ 0 & 1 & 0 \\ 0 & 0 & 1 \end{bmatrix}, \begin{bmatrix} 1 & 0 & 0 \\ 0 & 0 & 1 \\ 0 & 1 & 0 \end{bmatrix}, \begin{bmatrix} 0 & 1 & 0 \\ 1 & 0 & 0 \\ 0 & 0 & 1 \end{bmatrix}, \begin{bmatrix} 0 & 1 & 0 \\ 0 & 0 & 1 \\ 1 & 0 & 0 \end{bmatrix}, \begin{bmatrix} 0 & 0 & 1 \\ 1 & 0 & 0 \\ 0 & 1 & 0 \end{bmatrix}, \text{ or } \begin{bmatrix} 0 & 0 & 1 \\ 0 & 1 & 0 \\ 1 & 0 & 0 \end{bmatrix}.$$

When q=k=4, locations of zero elements and the non-zero elements of the first group structure are shown in any one of the following matrices:

$$\begin{bmatrix} 1 & 0 & 0 & 0 \\ 0 & 1 & 0 & 0 \\ 0 & 0 & 1 & 0 \\ 0 & 0 & 0 & 1 \end{bmatrix}, \begin{bmatrix} 1 & 0 & 0 & 0 \\ 0 & 1 & 0 & 0 \\ 0 & 0 & 0 & 1 \\ 0 & 0 & 1 & 0 \end{bmatrix}, \begin{bmatrix} 1 & 0 & 0 & 0 \\ 0 & 0 & 1 & 0 \\ 0 & 1 & 0 & 0 \\ 0 & 0 & 0 & 1 \end{bmatrix}, \begin{bmatrix} 1 & 0 & 0 & 0 \\ 0 & 0 & 1 & 0 \\ 0 & 0 & 0 & 1 \\ 0 & 1 & 0 & 0 \end{bmatrix}, \begin{bmatrix} 1 & 0 & 0 & 0 \\ 0 & 0 & 0 & 1 \\ 0 & 1 & 0 & 0 \\ 0 & 0 & 1 & 0 \end{bmatrix},$$

$$\begin{bmatrix} 1 & 0 & 0 & 0 \\ 0 & 0 & 0 & 1 \\ 0 & 0 & 1 & 0 \\ 0 & 1 & 0 & 0 \end{bmatrix}, \begin{bmatrix} 0 & 1 & 0 & 0 \\ 1 & 0 & 0 & 0 \\ 0 & 0 & 1 & 0 \\ 0 & 0 & 0 & 1 \end{bmatrix}, \begin{bmatrix} 0 & 1 & 0 & 0 \\ 1 & 0 & 0 & 0 \\ 0 & 0 & 1 & 0 \\ 0 & 0 & 0 & 1 \end{bmatrix}, \begin{bmatrix} 0 & 1 & 0 & 0 \\ 0 & 0 & 1 & 0 \\ 0 & 0 & 0 & 1 \\ 1 & 0 & 0 & 0 \end{bmatrix}, \begin{bmatrix} 0 & 1 & 0 & 0 \\ 0 & 0 & 1 & 0 \\ 1 & 0 & 0 & 0 \\ 0 & 0 & 0 & 1 \end{bmatrix},$$

$$\begin{bmatrix} 0 & 1 & 0 & 0 \\ 0 & 0 & 0 & 1 \\ 1 & 0 & 0 & 0 \\ 0 & 0 & 1 & 0 \end{bmatrix}, \begin{bmatrix} 0 & 1 & 0 & 0 \\ 0 & 0 & 0 & 1 \\ 0 & 0 & 1 & 0 \\ 1 & 0 & 0 & 0 \end{bmatrix}, \begin{bmatrix} 0 & 0 & 1 & 0 \\ 1 & 0 & 0 & 0 \\ 0 & 1 & 0 & 0 \\ 0 & 0 & 0 & 1 \end{bmatrix}, \begin{bmatrix} 0 & 0 & 1 & 0 \\ 1 & 0 & 0 & 0 \\ 0 & 0 & 0 & 1 \\ 0 & 1 & 0 & 0 \end{bmatrix}, \begin{bmatrix} 0 & 0 & 1 & 0 \\ 0 & 1 & 0 & 0 \\ 0 & 0 & 0 & 1 \\ 1 & 0 & 0 & 0 \end{bmatrix},$$

$$\begin{bmatrix} 0 & 0 & 1 & 0 \\ 0 & 1 & 0 & 0 \\ 1 & 0 & 0 & 0 \\ 0 & 0 & 0 & 1 \end{bmatrix}, \begin{bmatrix} 0 & 0 & 1 & 0 \\ 0 & 0 & 0 & 1 \\ 1 & 0 & 0 & 0 \\ 0 & 1 & 0 & 0 \end{bmatrix}, \begin{bmatrix} 0 & 0 & 1 & 0 \\ 0 & 0 & 0 & 1 \\ 0 & 1 & 0 & 0 \\ 1 & 0 & 0 & 0 \end{bmatrix}, \begin{bmatrix} 0 & 0 & 0 & 1 \\ 1 & 0 & 0 & 0 \\ 0 & 1 & 0 & 0 \\ 0 & 0 & 1 & 0 \end{bmatrix}, \begin{bmatrix} 0 & 0 & 0 & 1 \\ 1 & 0 & 0 & 0 \\ 0 & 0 & 1 & 0 \\ 0 & 1 & 0 & 0 \end{bmatrix},$$

$$\begin{bmatrix} 0 & 0 & 0 & 1 \\ 0 & 1 & 0 & 0 \\ 0 & 0 & 1 & 0 \\ 1 & 0 & 0 & 0 \end{bmatrix}, \begin{bmatrix} 0 & 0 & 0 & 1 \\ 0 & 1 & 0 & 0 \\ 1 & 0 & 0 & 0 \\ 0 & 0 & 1 & 0 \end{bmatrix}, \begin{bmatrix} 0 & 0 & 0 & 1 \\ 0 & 0 & 1 & 0 \\ 0 & 1 & 0 & 0 \\ 1 & 0 & 0 & 0 \end{bmatrix}, \text{or } \begin{bmatrix} 0 & 0 & 0 & 1 \\ 0 & 0 & 1 & 0 \\ 1 & 0 & 0 & 0 \\ 0 & 1 & 0 & 0 \end{bmatrix}.$$

It should be noted that the examples of the first group structure are merely for ease of understanding, and do not mean that the first group structure is limited thereto.

The following provides several examples of the second group structure.

When q=k=2, locations of zero elements and non-zero elements of the second group structure are shown in any one of the following matrices:

$$\begin{bmatrix} 1 & 0 \\ 0 & 0 \end{bmatrix}, \begin{bmatrix} 0 & 1 \\ 0 & 0 \end{bmatrix}, \begin{bmatrix} 0 & 0 \\ 0 & 1 \end{bmatrix}, \text{or } \begin{bmatrix} 0 & 0 \\ 1 & 0 \end{bmatrix}.$$

When q=k=3, locations of zero elements and non-zero elements of the second group structure are shown in any one of the following matrices:

$$\begin{bmatrix} 1 & 0 & 0 \\ 0 & 1 & 0 \\ 0 & 0 & 0 \end{bmatrix}, \begin{bmatrix} 1 & 0 & 0 \\ 0 & 0 & 0 \\ 0 & 0 & 0 \end{bmatrix}, \begin{bmatrix} 0 & 1 & 0 \\ 0 & 0 & 0 \\ 0 & 0 & 1 \end{bmatrix}, \text{or } \begin{bmatrix} 0 & 0 & 1 \\ 0 & 0 & 0 \\ 1 & 0 & 0 \end{bmatrix}.$$

When q=k=4, locations of zero elements and non-zero elements of the second group structure are shown in any one of the following matrices:

$$\begin{bmatrix} 1 & 0 & 0 & 0 \\ 0 & 1 & 0 & 0 \\ 0 & 0 & 1 & 0 \\ 0 & 0 & 0 & 0 \end{bmatrix}, \begin{bmatrix} 1 & 0 & 0 & 0 \\ 0 & 1 & 0 & 0 \\ 0 & 0 & 0 & 0 \\ 0 & 0 & 1 & 0 \end{bmatrix}, \begin{bmatrix} 1 & 0 & 0 & 0 \\ 0 & 0 & 1 & 0 \\ 0 & 0 & 0 & 0 \\ 0 & 0 & 0 & 1 \end{bmatrix}, \begin{bmatrix} 0 & 0 & 0 & 0 \\ 0 & 0 & 1 & 0 \\ 0 & 0 & 0 & 0 \\ 0 & 0 & 0 & 0 \end{bmatrix}, \begin{bmatrix} 0 & 0 & 0 & 0 \\ 0 & 0 & 0 & 0 \\ 0 & 1 & 0 & 0 \\ 0 & 0 & 1 & 0 \end{bmatrix},$$

or

$$\begin{bmatrix} 0 & 0 & 0 & 0 \\ 0 & 0 & 0 & 0 \\ 1 & 0 & 0 & 0 \\ 0 & 1 & 0 & 0 \end{bmatrix}.$$

It should be noted that the examples of the second group structure are merely for ease of understanding, and do not mean that the second group structure is limited thereto.

The following describes performance of the LDPC code in embodiments of this application with reference to simulation results.

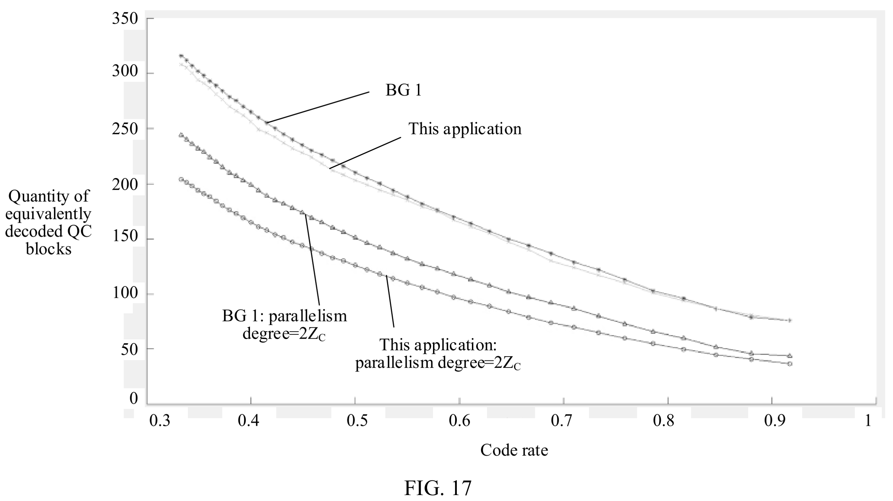

FIG. 17 shows simulation results of quantities of equivalently decoded QC blocks of LDPC codes at different code rates.

The quantity of equivalently decoded QC blocks may reflect performance in terms of complexity, a delay, and the like of decoding. FIG. 17 shows simulation results of quantities of equivalently decoded QC blocks that are of an NR LDPC code using a base graph 1 (base graph 1, BG 1) and an LDPC code using a group structure 2 (that is, the LDPC code in this application) and that are obtained at different code rates when quantities of QC blocks for parallel decoding are 1 and 2 (that is, parallelism degrees are 1 and 2).

As shown in FIG. 17, when the quantity of QC blocks for parallel decoding is 1, quantities of equivalently decoded QC blocks of the NR LDPC code using the BG 1 and the LDPC code using the group structure 2 are basically the same at the code rates (there is a slight decrease at a low code rate). In other words, when the parallelism degree is 1, introducing the column group structure 2 does not increase the decoding complexity, and does not cause a delay loss. When the quantity of QC blocks for parallel decoding is 1, in comparison with the NR LDPC code using the BG 1, a quantity of equivalently decoded QC blocks that are of the LDPC code using the group structure 2 and that are obtained at each code rate decreases. In other words, when the parallelism degree is 2, introducing the column group structure 2 may reduce the decoding complexity and the decoding delay.

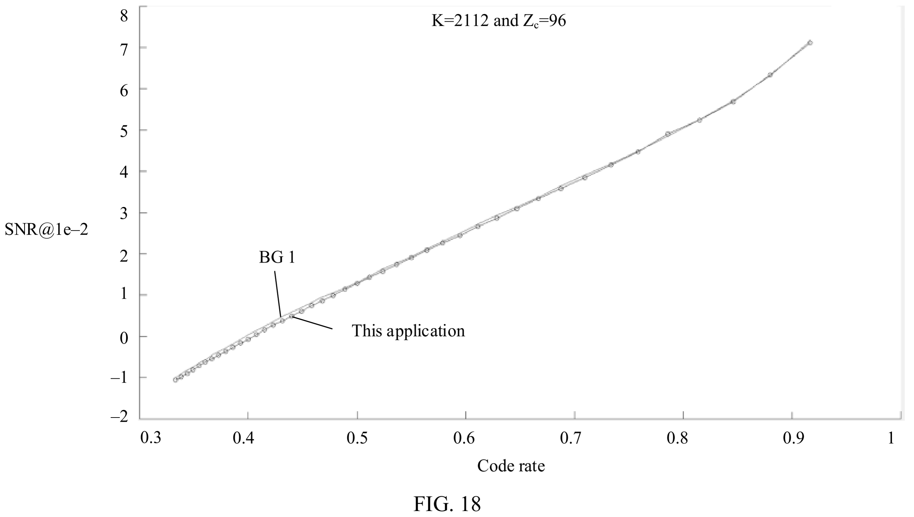

FIG. 18 shows simulation results of SNRs of LDPC codes at different code rates.

The signal-to-noise ratio may reflect ultimate performance of decoding. FIG. 18 shows simulation results of signal-to-noise ratios that are of an NR LDPC code using a BG 1 and an LDPC code using a group structure 2 and that are obtained at different code rates.

As shown in FIG. 18, the signal-to-noise ratios of the NR LDPC code using the BG 1 and the LDPC code using the group structure 2 are basically the same at the code rates. In other words, introducing the column group structure 2 does not cause a decoding performance loss.

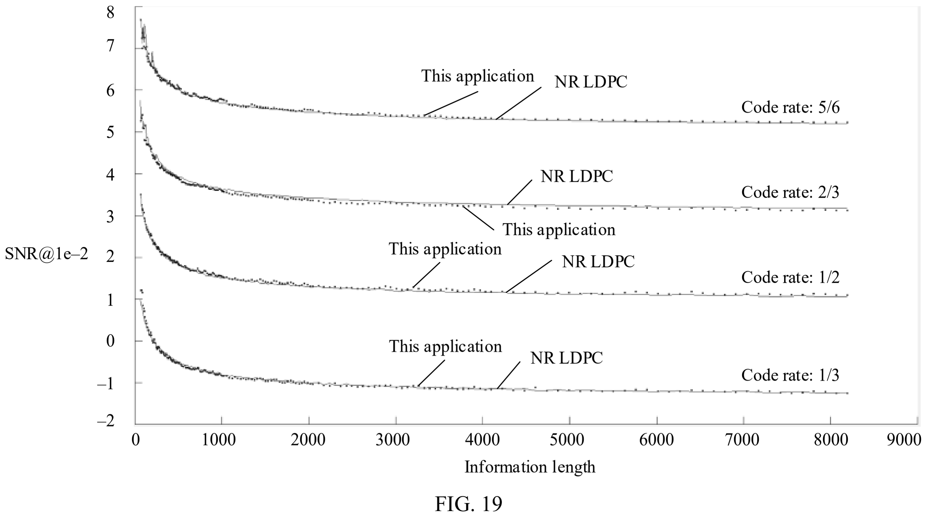

FIG. 19 shows simulation results 1 of signal-to-noise ratios of LDPC codes with different code lengths at different code rates.

FIG. 19 shows simulation results of signal-to-noise ratios that are of an NR LDPC code and an LDPC code using a group structure 2 and that are obtained in different code lengths (that is, information lengths (information lengths)) at different code rates by aligning iterative decoding times to 20 rounds. In FIG. 19, solid lines represent simulation results of the NR LDPC code, and dashed lines represent simulation results of the LDPC code using the group structure 2. As shown in FIG. 19, at code rates: 5/6, 2/3, 1/2, and 1/3, signal-to-noise ratios of the NR LDPC code and the LDPC code using the group structure 2 are basically the same in the code lengths. In other words, introducing the column group structure 2 does not cause a decoding performance loss.

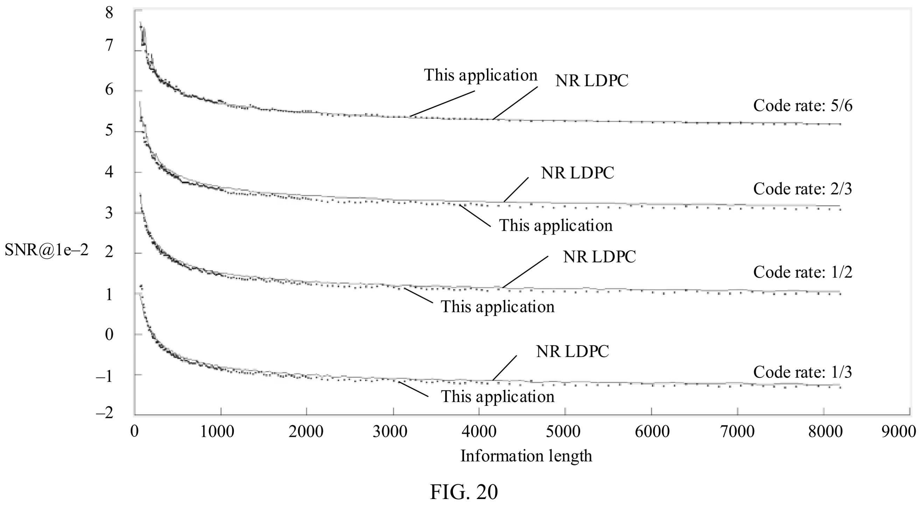

FIG. 20 shows simulation results 2 of signal-to-noise ratios of LDPC codes with different code lengths at different code rates.

FIG. 20 shows simulation results of signal-to-noise ratios that are of an NR LDPC code and an LDPC code using a group structure 2 and that are obtained in different code lengths at different code rates by aligning decoding delays (or complexity) to 20 rounds of NR iteration. In FIG. 20, solid lines represent simulation results of the NR LDPC code, and dashed lines represent simulation results of the LDPC code using the group structure 2. As shown in FIG. 20, in comparison with the NR LDPC code, except for a high code rate, in other code rates, performance gains of the aligned decoding delay of the LDPC code using the group structure 2 are about 0.1x dB.

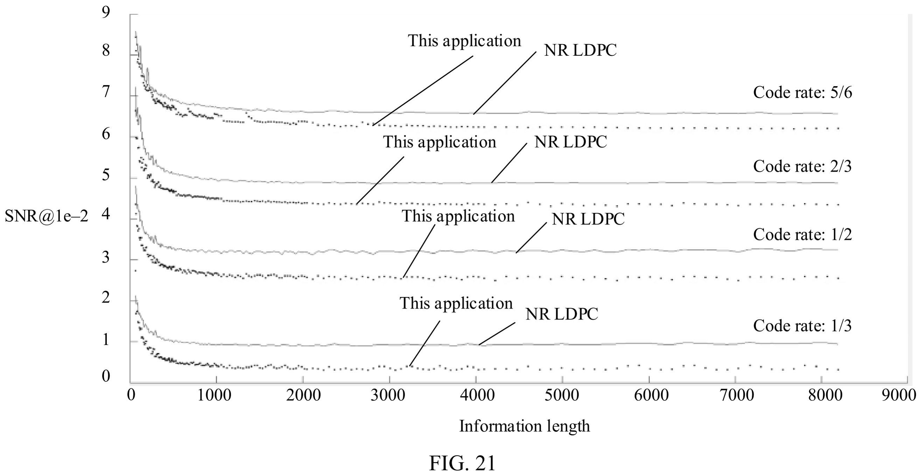

FIG. 21 shows simulation results 3 of signal-to-noise ratios of LDPC codes with different code lengths at different code rates.

FIG. 21 shows simulation results of signal-to-noise ratios that are of an NR LDPC code and an LDPC code using a group structure 2 and that are obtained in different code lengths at different code rates by aligning decoding delays (or complexity) to 4 rounds of NR iteration. In FIG. 21, solid lines represent simulation results of the NR LDPC code, and dashed lines represent simulation results of the LDPC code using the group structure 2. As shown in FIG. 21, in comparison with the NR LDPC code, except for a high code rate, in other code rates, performance gains of the aligned decoding delay of the LDPC code using the group structure 2 are about 0.3x dB.

It should be noted that in each of the foregoing embodiments, a group structure of one scale is used in the LDPC base matrix. Actually, group mechanisms of a plurality of scales may be used in the LDPC base matrix. For example, the group mechanism 2 is used in the kernel matrix of the LDPC base matrix, and the group structure 1 is used in the extension region of the LDPC base matrix. This is not limited.

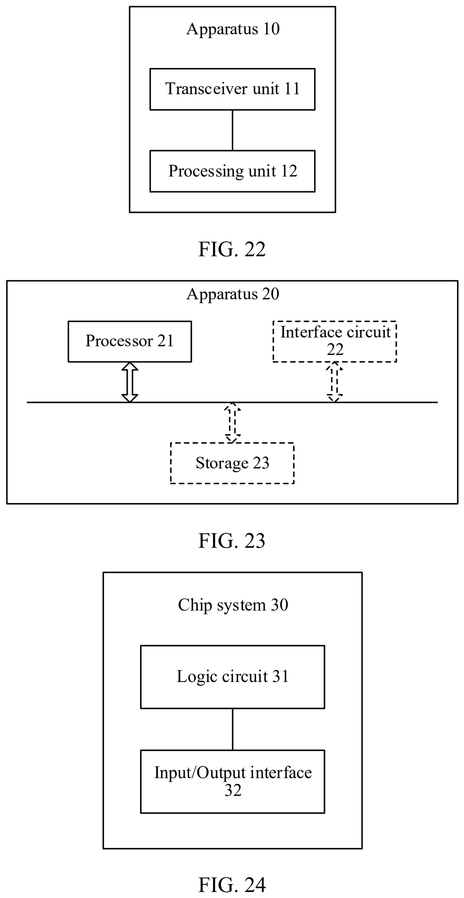

The foregoing describes in detail the method embodiments provided in this application with reference to FIG. 1 to FIG. 21. The following describes apparatus embodiments of this application with reference to FIG. 22 to FIG. 24.

It may be understood that, to implement functions in the foregoing embodiments, apparatuses in FIG. 22 to FIG. 24 include corresponding hardware structures and/or software modules for performing the functions. A person skilled in the art should be easily aware that, with reference to units and method steps of the examples described in embodiments disclosed in this application, this application can be implemented by hardware or a combination of hardware and computer software.

FIG. 22 and FIG. 23 are diagrams of structures of possible apparatuses according to embodiments of this application. These apparatuses may be configured to implement functions of the transmitter device or the receiver device in the foregoing method embodiments. Therefore, beneficial effect of the foregoing method embodiments can also be implemented.

As shown in FIG. 22, an apparatus 10 includes a transceiver unit 11 and a processing unit 12.

When the apparatus 10 is configured to implement functions of the transmitter device in FIG. 10, the transceiver unit 11 is configured to perform sending and receiving steps of the transmitter device, for example, step 1003. The processing unit 12 is configured to perform processing steps of the transmitter device, for example, step 1001 and step 1002. When the apparatus 10 is configured to implement functions of the receiver device in FIG. 10, the transceiver unit 11 is configured to perform sending and receiving steps of the receiver device, for example, step 1003. The processing unit 12 is configured to perform a processing step of the receiver device, for example, step 1004.

For more detailed descriptions of the transceiver unit 11 and the processing unit 12, refer to related descriptions in the foregoing method embodiments. Details are not described herein again.

As shown in FIG. 23, an apparatus 20 includes a processor 21. The processor 21 is coupled to a storage 23. The storage 23 is configured to store instructions. When the apparatus 20 is configured to implement the foregoing method, the processor 21 is configured to execute the instructions in the storage 23, to implement a function of the foregoing processing unit 12.

Optionally, the apparatus 20 further includes the storage 23.

Optionally, the apparatus 20 further includes an interface circuit 22. The processor 21 and the interface circuit 22 are coupled to each other. It may be understood that the interface circuit 22 may be a transceiver or an input/output interface. When the apparatus 20 is configured to implement the foregoing method, the processor 21 is configured to execute the instructions to implement the function of the foregoing processing unit 12, and the interface circuit 22 is configured to implement a function of the foregoing transceiver unit 11.

For example, when the apparatus 20 is a chip used at a transmitter device or a receiver device, the chip implements functions of the transmitter device or the receiver device in the foregoing method embodiments. The chip receives information from another module (for example, a radio frequency module or an antenna) in the transmitter device or the receiver device, where the information is sent by another apparatus to the transmitter device or the receiver device; or the chip sends information to another module (for example, a radio frequency module or an antenna) in the transmitter device or the receiver device, where the information is sent by the transmitter device or the receiver device to another apparatus.

FIG. 24 is a diagram of a chip system 30 according to an embodiment of this application. The chip system 30 (or may be referred to as a processing system) includes a logic circuit 31 and an input/output interface (input/output interface) 32.

The logic circuit 31 may be a processing circuit in the chip system 30. The logic circuit 31 may be coupled to a storage unit, and invoke instructions in the storage unit, to enable the chip system 30 to implement the methods and functions in embodiments of this application. The input/output interface 32 may be an input/output circuit in the chip system 30, and outputs information processed by the chip system 30, or inputs to-be-processed data or signaling information into the chip system 30 for processing.

In a solution, the chip system 30 is configured to implement the operations performed by the transmitter device or the receiver device in the foregoing method embodiments.

For example, the logic circuit 31 is configured to implement processing-related operations performed by the transmitter device or the receiver device in the foregoing method embodiments. The input/output interface 32 is configured to implement sending and/or receiving-related operations performed by the transmitter device or the receiver device in the foregoing method embodiments.

This application further provides a communication apparatus, including a processor. The processor is coupled to a storage. The storage is configured to store a computer program or instructions and/or data. The processor is configured to execute the computer program or the instructions stored in the storage, or read the data stored in the storage, to perform the method in the foregoing method embodiments. Optionally, there are one or more processors. Optionally, the communication apparatus includes the storage. Optionally, there are one or more storages. Optionally, the storage and the processor are integrated together or disposed separately.

This application further provides a chip, including a processor. The processor is coupled to a storage. The storage is configured to store a computer program or instructions. The processor is configured to execute the computer program or the instructions stored in the storage, to implement the method performed by the transmitter device or the receiver device in the foregoing method embodiments.

This application further provides a computer-readable storage medium. The computer-readable storage medium stores computer instructions for implementing the method performed by the transmitter device or the receiver device in the foregoing method embodiments.

This application further provides a computer program product, including instructions. When the instructions are executed by a computer, the method performed by the transmitter device or the receiver device in the foregoing method embodiments is implemented.

This application further provides a communication system. The communication system includes at least one of the transmitter device or the receiver device in the foregoing embodiments.

For explanations and beneficial effects of related content of any one of the apparatuses provided above, refer to the corresponding method embodiments provided above. Details are not described herein again.

It may be understood that, the processor in embodiments of this application may be a central processing unit (central processing unit, CPU), or may be another general-purpose processor, a digital signal processor (digital signal processor, DSP), an application-specific integrated circuit (application-specific integrated circuit, ASIC), a field programmable gate array (field programmable gate array, FPGA) or another programmable logic device, a transistor logic device, a hardware component, or any combination thereof. The general-purpose processor may be a microprocessor, or may be any conventional processor.

The method steps in embodiments of this application may be implemented in a hardware manner, or may be implemented in a manner of executing software instructions by the processor. The software instructions may include a corresponding software module. The software module may be stored in a random access memory, a flash memory, a read-only memory, a programmable read-only memory, an erasable programmable read-only memory, an electrically erasable programmable read-only memory, a register, a hard disk, a removable hard disk, a compact disc read-only memory (compact disc read-only memory, CD-ROM), or any other form of storage medium well-known in the art. For example, a storage medium is coupled to a processor, so that the processor can read information from the storage medium and write information into the storage medium. Certainly, the storage medium may alternatively be a component of the processor. The processor and the storage medium may be located in an ASIC. In addition, the ASIC may be located in a transmitter device or a receiver device. Certainly, the processor and the storage medium may alternatively exist in the transmitter device or the receiver device as discrete components.

All or some of the foregoing embodiments may be implemented by using software, hardware, firmware, or any combination thereof. When the software is used to implement embodiments, all or some of embodiments may be implemented in a form of a computer program product. The computer program product includes one or more computer programs or instructions. When the computer programs or the instructions are loaded and executed on a computer, the procedures or functions in embodiments of this application are all or partially executed. The computer may be a general-purpose computer, a dedicated computer, a computer network, a network device, user equipment, or another programmable apparatus. The computer programs or the instructions may be stored in a computer-readable storage medium, or may be transmitted from a computer-readable storage medium to another computer-readable storage medium. For example, the computer programs or the instructions may be transmitted from a website, computer, server, or data center to another website, computer, server, or data center in a wired or wireless manner. The computer-readable storage medium may be any usable medium accessible by the computer, or a data storage device, for example, a server or a data center, integrating one or more usable media. The usable medium may be a magnetic medium, for example, a floppy disk, a hard disk, or a magnetic tape; or may be an optical medium, for example, a digital video disc; or may be a semiconductor medium, for example, a solid-state drive.

In embodiments of this application, unless otherwise specified or logically conflicted, terms and/or descriptions in different embodiments are consistent and may be mutually referenced, and technical features in different embodiments may be combined based on an internal logical relationship thereof, to form a new embodiment.

Unless otherwise specified, meanings of all technical and scientific terms used in embodiments of this application are the same as those usually understood by a person skilled in the art of this application. The terms used in this application are merely intended to describe specific embodiments, and are not intended to limit the scope of this application. It should be understood that the foregoing is an example for description, and the foregoing examples are merely intended to help a person skilled in the art understand embodiments of this application, but are not intended to limit embodiments of this application to examples of specific values or specific scenarios. It is clear that a person skilled in the art can make various equivalent modifications or variations based on the examples described above, and such modifications and variations also fall within the scope of embodiments of this application.

**Claims**

1.   A low-density parity check LDPC code-based communication method, wherein the method comprises:

   obtaining an information bit sequence;
   performing LDPC encoding on the information bit sequence based on an LDPC base matrix to obtain a first LDPC codeword sequence, wherein a $(q \times (i-1)+1)^{th}$ row to a $(q \times i)^{th}$ row of a first part of the LDPC base matrix comprise $M_i$ first units, $F_i$ second units, and $G_i$ third units; the first part is a matrix region consisting of a $1^{st}$ column to an $x^{th}$ column of the LDPC base matrix; the first unit is a matrix with q rows and k columns, and a column weight of each column is 1; the second unit is a matrix with q rows and k columns, a column weight of at least one column of the second unit is 1, and a column weight of a remaining column is 0; the third unit is a matrix with q rows and k columns, and a column weight of each column is 0; i and q are positive integers; x and k are integers greater than or equal to 2; $M_i$ is a positive integer; and $F_i$ and $G_i$ are nonnegative integers; and
   outputting a second LDPC codeword sequence based on the first LDPC codeword sequence.

2.   The method according to claim 1, wherein the outputting the second LDPC codeword sequence based on the first LDPC codeword sequence comprises:

performing first interleaving between a part that is in the first LDPC codeword sequence and that corresponds to an information column of the LDPC base matrix and a part that is in the first LDPC codeword sequence and that corresponds to a kernel check column of the LDPC base matrix, to obtain the second LDPC codeword sequence, wherein the first interleaving is performed at a granularity of columns whose quantity is a lifting value, and a quantity of second units comprised in a base matrix corresponding to the second LDPC codeword sequence is less than a quantity of second units comprised in the base matrix corresponding to the first LDPC codeword sequence; and

outputting the second LDPC codeword sequence.

3. A low-density parity check LDPC code-based communication method, wherein the method comprises:

receiving a second LDPC codeword sequence; and

decoding the second LDPC codeword sequence based on an LDPC base matrix, wherein a $(q \times (i-1)+1)^{th}$ row to a $(q \times i)^{th}$ row of a first part of the LDPC base matrix comprise $M_i$ first units, $F_i$ second units, and $G_i$ third units; the first part is a matrix region consisting of a $1^{st}$ column to an $x^{th}$ column of the LDPC base matrix; the first unit is a matrix with q rows and k columns, and a column weight of each column is 1; the second unit is a matrix with q rows and k columns, a column weight of at least one column of the second unit is 1, and a column weight of a remaining column is 0; the third unit is a matrix with q rows and k columns, and a column weight of each column is 0; i and q are positive integers; x and k are integers greater than or equal to 2; $M_i$ is a positive integer; and $F_i$ and $G_i$ are nonnegative integers.

4. The method according to claim 3, wherein the decoding the second LDPC codeword sequence based on the LDPC base matrix comprises:

performing first column transformation between an information column and a kernel check column of the LDPC base matrix, wherein the first column transformation is performed at a granularity of columns whose quantity is a lifting value, and a quantity of second units comprised in the LDPC base matrix obtained through the first column transformation is less than a quantity of second units comprised in the LDPC base matrix on which no first column transformation is performed; and

decoding the second LDPC codeword sequence based on the LDPC base matrix obtained through the first column transformation.

5. The method according to any one of claims 1 to 4, wherein

when $i_1$ is less than $i_2$, $F_{i1}$ is greater than $F_{i2}$, $F_{i1}$ is a value of $F_i$ when $i=i_1$, and $F_{i2}$ is a value of $F_i$ when $i=i_2$.

6. The method according to claims 1 to 4, wherein

a value range of i comprises a plurality of consecutive subranges, same subranges correspond to same $F_i$, and $F_i$ decreases in order of the subranges.

7. The method according to claim 6, wherein

when i is less than a first value, $F_i$ is greater than 0; or

when i is greater than or equal to the first value, $F_i$ is 0.

8. The method according to claim 6, wherein

when i is less than a second value, a threshold $V_i$ is 2;

when i is greater than or equal to a second value and less than a third value, a threshold $V_i$ is 1; or

when i is greater than or equal to a third value, a threshold $V_i$ is 0.

9. The method according to any one of claims 1 to 8, wherein

the $M_i$ first units, the $F_i$ second units, and the $G_i$ third units are comprised in a non-punctured information column in the $1^{st}$ column to the $x^{th}$ column of the LDPC base matrix;

the $M_i$ first units, the $F_i$ second units, and the $G_i$ third units are comprised in an information column in the $1^{st}$ column to the $x^{th}$ column of the LDPC base matrix; or

the $M_i$ first units, the $F_i$ second units, and the $G_i$ third units are comprised in a non-punctured column in the $1^{st}$ column to the $x^{th}$ column of the LDPC base matrix.

**10.** The method according to any one of claims 1 to 9, wherein q=1.

**11.** The method according to claim 10, wherein a sum of shifting values of non-zero elements in the first unit is an integer multiple of the lifting value.

**12.** The method according to claim 10 or 11, wherein
when a code rate is greater than a first code rate threshold, $F_i$ is 0.

**13.** The method according to claim 12, wherein
the first code rate threshold is any one of the following code rates: 0.926, $\frac{22}{24}$, $\frac{22}{25}$, or $\frac{22}{26}$.

**14.** The method according to any one of claims 1 to 13, wherein

the LDPC base matrix comprises a punctured column; and
at most one of the $F_i$ second units comprises the punctured column.

**15.** The method according to any one of claims 1 to 14, wherein
a matrix region corresponding to a non-punctured information column of the LDPC base matrix does not comprise the second unit.

**16.** The method according to any one of claims 1 to 15, wherein

the first part comprises a first subpart, the first subpart is a matrix region consisting of a $1^{st}$ row to a $u^{th}$ row and a $(y+1)^{th}$ column to an $x^{th}$ column of the first part, u is an integer greater than or equal to 1, u-1=x-y-1, and y is less than x; and
diagonal elements in the first subpart are all non-zero elements, the first subpart comprises N blocks, the block is a square matrix, the N blocks comprise all of the diagonal elements in the first subpart, a diagonal element in each of the N blocks overlaps the diagonal element in the first subpart, the blocks do not overlap, a part or all of the N blocks comprise a plurality of rows, and non-zero elements in at least two of the plurality of rows have a proper inclusion relationship.

**17.** The method according to claim 16, wherein
the N blocks consist of N1 first blocks and one second block, a size of the first block is k×k, a size of the second block is k'×k', N1 is a positive integer, N2 is a nonnegative integer, and k' is less than k.

**18.** The method according to claim 16 or 17, wherein
each element other than the N blocks in the first subpart is a zero element.

**19.** The method according to any one of claims 1 to 18, wherein

the first part comprises the first subpart, the first subpart is the matrix region consisting of the $1^{st}$ row to the $u^{th}$ row and the $(y+1)^{th}$ column to the $x^{th}$ column of the first part, u is an integer greater than or equal to 1, u-1=x-y-1, and y is less than x, wherein
when u-1=x-y-1=3, locations of zero elements and non-zero elements in the first subpart are shown in the following matrix:

$$\begin{bmatrix} 1 & 1 & 0 \\ 0 & 1 & 0 \\ 0 & 0 & 1 \end{bmatrix};$$

when u-1=x-y-1=4, locations of zero elements and non-zero elements in the first subpart are shown in either of the following matrices:

$$\begin{bmatrix} 1 & 1 & 0 & 0 \\ 0 & 1 & 0 & 0 \\ 0 & 0 & 1 & 1 \\ 0 & 0 & 0 & 1 \end{bmatrix} \text{ or } \begin{bmatrix} 1 & 1 & 1 & 0 \\ 0 & 1 & 1 & 0 \\ 0 & 0 & 1 & 0 \\ 0 & 0 & 0 & 1 \end{bmatrix};$$

and/or
when u-1=x-y-1=5, locations of zero elements and non-zero elements in the first subpart are shown in any one of the following matrices:

$$\begin{bmatrix} 1 & 1 & 0 & 0 & 0 \\ 0 & 1 & 0 & 0 & 0 \\ 0 & 0 & 1 & 1 & 0 \\ 0 & 0 & 0 & 1 & 0 \\ 0 & 0 & 0 & 0 & 1 \end{bmatrix}, \begin{bmatrix} 1 & 1 & 1 & 0 & 0 \\ 0 & 1 & 1 & 0 & 0 \\ 0 & 0 & 1 & 0 & 0 \\ 0 & 0 & 0 & 1 & 1 \\ 0 & 0 & 0 & 0 & 1 \end{bmatrix}, \text{ or } \begin{bmatrix} 1 & 1 & 1 & 1 & 0 \\ 0 & 1 & 1 & 1 & 0 \\ 0 & 0 & 1 & 1 & 0 \\ 0 & 0 & 0 & 1 & 0 \\ 0 & 0 & 0 & 0 & 1 \end{bmatrix},$$

wherein
in the foregoing matrices, "1" represents a non-zero element, and "0" represents a non-zero element.

20. The method according to any one of claims 1 to 9, wherein q=k.

21. The method according to claim 20, wherein
a row weight of each row of the first unit is 1.

22. The method according to claim 21, wherein
each first unit is obtained through permutation of a sequence $\theta$ ($\theta_1, \theta_2, ..., \theta_a, ..., \theta_k$) whose length is k, the $a^{th}$ element $\theta_a$ of $\theta$ represents that an element in an $a^{th}$ row and a $(\theta_a)^{th}$ column of the first unit is a non-zero element, and a is an integer greater than 0 and less than or equal to k.

23. The method according to claim 22, wherein
$\theta_a$=a+b(mod k), or 8a=k+1-a+b(mod k), wherein b is a constant.

24. The method according to any one of claims 21 to 23, wherein

shifting values of non-zero elements in the first unit are the same;
remainders of any two non-zero elements in the first unit relative to the lifting value are the same; or
a sum of shifting values of non-zero elements in the first unit is an integer multiple of the lifting value.

25. The method according to any one of claims 21 to 24, wherein

when q=k=2, locations of zero elements and the non-zero elements in the first unit are shown in either of the following matrices:

$$\begin{bmatrix} 1 & 0 \\ 0 & 1 \end{bmatrix} \text{ or } \begin{bmatrix} 0 & 1 \\ 1 & 0 \end{bmatrix};$$

when q=k=3, locations of zero elements and the non-zero elements in the first unit are shown in any one of the following matrices:

$$\begin{bmatrix} 1 & 0 & 0 \\ 0 & 1 & 0 \\ 0 & 0 & 1 \end{bmatrix}, \begin{bmatrix} 1 & 0 & 0 \\ 0 & 0 & 1 \\ 0 & 1 & 0 \end{bmatrix}, \begin{bmatrix} 0 & 1 & 0 \\ 1 & 0 & 0 \\ 0 & 0 & 1 \end{bmatrix}, \begin{bmatrix} 0 & 1 & 0 \\ 0 & 0 & 1 \\ 1 & 0 & 0 \end{bmatrix}, \begin{bmatrix} 0 & 0 & 1 \\ 1 & 0 & 0 \\ 0 & 1 & 0 \end{bmatrix}, \text{ or } \begin{bmatrix} 0 & 0 & 1 \\ 0 & 1 & 0 \\ 1 & 0 & 0 \end{bmatrix};$$

and/or
when q=k=4, locations of zero elements and the non-zero elements in the first unit are shown in any one of the following matrices:

$$\begin{bmatrix}1&0&0&0\\0&1&0&0\\0&0&1&0\\0&0&0&1\end{bmatrix}, \begin{bmatrix}1&0&0&0\\0&1&0&0\\0&0&0&1\\0&0&1&0\end{bmatrix}, \begin{bmatrix}1&0&0&0\\0&0&1&0\\0&1&0&0\\0&0&0&1\end{bmatrix}, \begin{bmatrix}1&0&0&0\\0&0&1&0\\0&0&0&1\\0&1&0&0\end{bmatrix}, \begin{bmatrix}1&0&0&0\\0&0&0&1\\0&1&0&0\\0&0&1&0\end{bmatrix},$$

$$\begin{bmatrix}1&0&0&0\\0&0&0&1\\0&0&1&0\\0&1&0&0\end{bmatrix}, \begin{bmatrix}0&1&0&0\\1&0&0&0\\0&0&1&0\\0&0&0&1\end{bmatrix}, \begin{bmatrix}0&1&0&0\\1&0&0&0\\0&0&1&0\\0&0&0&1\end{bmatrix}, \begin{bmatrix}0&1&0&0\\0&0&1&0\\0&0&0&1\\1&0&0&0\end{bmatrix}, \begin{bmatrix}0&1&0&0\\0&0&1&0\\1&0&0&0\\0&0&0&1\end{bmatrix},$$

$$\begin{bmatrix}0&1&0&0\\0&0&0&1\\1&0&0&0\\0&0&1&0\end{bmatrix}, \begin{bmatrix}0&1&0&0\\0&0&0&1\\0&0&1&0\\1&0&0&0\end{bmatrix}, \begin{bmatrix}0&0&1&0\\1&0&0&0\\0&1&0&0\\0&0&0&1\end{bmatrix}, \begin{bmatrix}0&0&1&0\\1&0&0&0\\0&0&0&1\\0&1&0&0\end{bmatrix}, \begin{bmatrix}0&0&1&0\\0&1&0&0\\0&0&0&1\\1&0&0&0\end{bmatrix},$$

$$\begin{bmatrix}0&0&1&0\\0&1&0&0\\1&0&0&0\\0&0&0&1\end{bmatrix}, \begin{bmatrix}0&0&1&0\\0&0&0&1\\1&0&0&0\\0&1&0&0\end{bmatrix}, \begin{bmatrix}0&0&1&0\\0&0&0&1\\0&1&0&0\\1&0&0&0\end{bmatrix}, \begin{bmatrix}0&0&0&1\\1&0&0&0\\0&1&0&0\\0&0&1&0\end{bmatrix}, \begin{bmatrix}0&0&0&1\\1&0&0&0\\0&0&1&0\\0&1&0&0\end{bmatrix},$$

$$\begin{bmatrix}0&0&0&1\\0&1&0&0\\0&0&1&0\\1&0&0&0\end{bmatrix}, \begin{bmatrix}0&0&0&1\\0&1&0&0\\1&0&0&0\\0&0&1&0\end{bmatrix}, \begin{bmatrix}0&0&0&1\\0&0&1&0\\0&1&0&0\\1&0&0&0\end{bmatrix}, \text{ or } \begin{bmatrix}0&0&0&1\\0&0&1&0\\1&0&0&0\\0&1&0&0\end{bmatrix},$$

wherein

in the foregoing matrices, "1" represents a non-zero element, and "0" represents a non-zero element.

26. The method according to any one of claims 1 to 25, wherein
the LDPC base matrix is obtained based on an indicator matrix, one element in the indicator matrix corresponds to one element in the first unit, the second unit, or the third unit, and a value of the element in the indicator matrix indicates locations/a location of a zero element and/or a non-zero element that are/is in the first unit, the second unit, or the third unit and that correspond/corresponds to the element.

27. The method according to any one of claims 1 to 25, wherein
a row number of a row in a matrix region comprising the first unit, the second unit, and the third unit is greater than a row number of a row in a matrix region corresponding to a first code rate, and the first code rate is greater than a code rate threshold.

28. The method according to any one of claims 1 to 27, wherein $F_i$ is related to at least one of the following information: code rates corresponding to the $(q \times (i-1)+1)^{th}$ row to the $(q \times i)^{th}$ row, row weights of the $(qx(i-1)+1)^{th}$ row to the $(q \times i)^{th}$ row, or locations/a location of a zero element and/or a non-zero element in the $(q \times (i-1)+1)^{th}$ row to the $(q \times i)^{th}$ row of the punctured column of the LDPC base matrix.

29. A communication apparatus, comprising a module or a unit configured to perform the method according to any one of claims 1 to 28.

30. A communication apparatus, comprising a processor and an interface circuit, wherein the interface circuit is configured to: receive a signal from a communication apparatus other than the communication apparatus and transmit the signal to the processor, or send a signal from the processor to a communication apparatus other than the communication apparatus, and the processor is configured to implement the method according to any one of claims 1 to 28 by using a logic circuit or by executing code instructions.

31. The communication apparatus according to claim 30, wherein the communication apparatus is a chip or a chip system.

**32.** A computer-readable storage medium, wherein the storage medium stores a computer program or instructions, and when the computer program or the instructions are executed by a communication apparatus, the method according to any one of claims 1 to 28 is implemented.

**33.** A computer program product, comprising a computer program, wherein when the computer program is run, the method according to any one of claims 1 to 28 is implemented.

**34.** A communication system, comprising:

a transmitter device configured to perform the method according to any one of claims 1, 2, and 5 to 28; and
a receiver device configured to perform the method according to any one of claims 3 to 28.

FIG. 1

$$H = \begin{array}{cccccccc} V_1 & V_2 & V_3 & V_4 & V_5 & V_6 & V_7 & V_8 \end{array}$$

$$H = \left(\begin{array}{cccccccc} 1 & 0 & 1 & 0 & 1 & 0 & 1 & 0 \\ 1 & 0 & 0 & 1 & 0 & 1 & 0 & 1 \\ 0 & 1 & 1 & 0 & 0 & 1 & 1 & 0 \\ 0 & 0 & 0 & 1 & 1 & 0 & 0 & 1 \end{array}\right) \begin{array}{c} C_1 \\ C_2 \\ C_3 \\ C_4 \end{array}$$

FIG. 2

FIG. 3

| High rate region | All-zero region |
|---|---|
| Incremental redundancy region | Raptor-like region |

(a)

| A | B | C |
|---|---|---|
| D | | E |

(b)

FIG. 4

| 1 | 0 | 0 |
|---|---|---|
| 0 | 0 | 1 |

(a)

| 0 | 0 | 1 |
|---|---|---|
| 1 | 1 | 0 |

(b)

FIG. 5

| 1 | 1 | 0 |
|---|---|---|
| 0 | 0 | 1 |

(a)

| 1 | 0 | 0 |
|---|---|---|
| 0 | 0 | 1 |

(b)

| 1 | 1 | 1 |
|---|---|---|

(c)

FIG. 6

FIG. 7

| 1 | 2 | 3 | 4 | 5 | 6 | 7 | 8 | 9 | 10 | 11 | 12 | 13 | 14 | 15 | 16 | 17 | 18 | 19 | 20 | 21 | 22 | 23 | 24 | 25 | 26 |
|---|---|---|---|---|---|---|---|---|----|----|----|----|----|----|----|----|----|----|----|----|----|----|----|----|----|
| 1 | 1 | 0 | 0 | 0 | 0 | 1 | 1 | 0 | 0 | 1 | 1 | 0 | 0 | 0 | 0 | 1 | 1 | 0 | 0 | 0 | 0 | 0 | 0 | 0 | 0 |
| 0 | 0 | 1 | 1 | 1 | 1 | 0 | 0 | 1 | 1 | 0 | 0 | 1 | 1 | 1 | 1 | 0 | 0 | 1 | 1 | 0 | 0 | 0 | 0 | 0 | 0 |
| 1 | 1 | 0 | 0 | 1 | 1 | 0 | 0 | 1 | 1 | 0 | 0 | 0 | 0 | 0 | 0 | 0 | 0 | 0 | 0 | 1 | 1 | 0 | 0 | 1 | 1 |
| 0 | 0 | 1 | 1 | 0 | 0 | 1 | 1 | 0 | 0 | 1 | 1 | 1 | 1 | 0 | 0 | 0 | 0 | 0 | 0 | 0 | 0 | 1 | 1 | 0 | 0 |
| 0 | 0 | 1 | 1 | 1 | 1 | 0 | 0 | 0 | 0 | 0 | 0 | 0 | 0 | 0 | 0 | 1 | 1 | 0 | 0 | 0 | 0 | 1 | 1 | 0 | 0 |
| 1 | 1 | 0 | 0 | 0 | 0 | 1 | 1 | 0 | 0 | 0 | 0 | 0 | 0 | 1 | 1 | 0 | 0 | 1 | 1 | 1 | 1 | 0 | 0 | 1 | 1 |
| 0 | 0 | 0 | 0 | 0 | 0 | 0 | 0 | 1 | 1 | 0 | 0 | 1 | 1 | 0 | 0 | 0 | 0 | 1 | 1 | 1 | 1 | 0 | 0 | 0 | 0 |
| 1 | 1 | 0 | 0 | 0 | 0 | 0 | 0 | 0 | 0 | 1 | 1 | 0 | 0 | 1 | 1 | 1 | 1 | 0 | 0 | 0 | 0 | 1 | 1 | 1 | 1 |

FIG. 8

```
Source ──→ Source
            encoding ──→ Channel
                         encoding ──→ Modulation ──┐
                                                    │
Sink ←── Source   ←── Channel   ←── Demodulation ←──┘
         recovery      decoding
```

**FIG. 9**

<u>1000</u>

```
Transmitter                              Receiver device
device

1001: Obtain an information bit
sequence

1002: Encode the information bit
sequence based on an LDPC
base matrix, to obtain a first
LDPC codeword sequence

────── 1003: Second LDPC codeword sequence ──────→

                              1004: Decode the second LDPC
                              codeword sequence based on an
                              LDPC base matrix
```

**FIG. 10**

VN storage: two
variable nodes

VN storage

CN storage → Addition

CN storage: two
check nodes

QC-LDPC shift
network 1

QC-LDPC shift
network 2

CN storage → Subtraction

min

Read, compute, and temporarily store
the two variable nodes in parallel

(a)

VN storage: two
variable nodes

VN storage

CN storage → Addition

CN storage: one
check node

QC-LDPC shift
network 1

QC-LDPC shift
network 2

CN storage → Subtraction

min

Read, compute, and temporarily store
the two variable nodes in parallel

(b)

FIG. 11

FIG. 12

FIG. 13

FIG. 14

(a)            (b)            (c)

(d)            (e)

FIG. 15

FIG. 16

FIG. 17

EP 4 746 323 A1

FIG. 18

FIG. 19

FIG. 20

FIG. 21

Apparatus 10

Transceiver unit 11

Processing unit 12

FIG. 22

Apparatus 20

Processor 21

Interface circuit 22

Storage 23

FIG. 23

Chip system 30

Logic circuit 31

Input/Output interface 32

FIG. 24

## INTERNATIONAL SEARCH REPORT

| International application No. |
| --- |
| **PCT/CN2023/112966** |

**A. CLASSIFICATION OF SUBJECT MATTER**

H04L1/00(2006.01)i; H03M13/11(2006.01)i

According to International Patent Classification (IPC) or to both national classification and IPC

**B. FIELDS SEARCHED**

Minimum documentation searched (classification system followed by classification symbols)

IPC:H04L H03M

Documentation searched other than minimum documentation to the extent that such documents are included in the fields searched

Electronic data base consulted during the international search (name of data base and, where practicable, search terms used)

CNTXT, ENTXTC, DWPI, WPABS: 并行, 同时, 准循环, QC, 低密度奇偶校验, LDPC, 编码, 解码, 译码, 行重, 列重, 分组, 分块, 子矩阵, parallel, simultaneous, quasi-cyclic , low-density parity check, code, decode, row weight, column weight, group, block, submatrix

**C. DOCUMENTS CONSIDERED TO BE RELEVANT**

| Category* | Citation of document, with indication, where appropriate, of the relevant passages | Relevant to claim No. |
| --- | --- | --- |
| A | CN 108270448 A (ZTE CORP.) 10 July 2018 (2018-07-10) description, paragraphs 0045-0090 | 1-34 |
| A | CN 104821831 A (SOUTHEAST UNIVERSITY) 05 August 2015 (2015-08-05) entire document | 1-34 |
| A | WO 2015133321 A1 (SONY CORP.) 11 September 2015 (2015-09-11) entire document | 1-34 |

| ☐ Further documents are listed in the continuation of Box C. | ☑ See patent family annex. |
| --- | --- |

| \* Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| **19 April 2024** | **24 April 2024** |

| Name and mailing address of the ISA/CN | Authorized officer |
| --- | --- |
| **China National Intellectual Property Administration (ISA/ CN)** **China No. 6, Xitucheng Road, Jimenqiao, Haidian District, Beijing 100088** | |
| | Telephone No. |

Form PCT/ISA/210 (second sheet) (July 2022)

INTERNATIONAL SEARCH REPORT
Information on patent family members

International application No.

**PCT/CN2023/112966**

| Patent document cited in search report | | | Publication date (day/month/year) | Patent family member(s) | | | Publication date (day/month/year) |
|---|---|---|---|---|---|---|---|
| CN | 108270448 | A | 10 July 2018 | WO | 2018126788 | A1 | 12 July 2018 |
| CN | 104821831 | A | 05 August 2015 | None | | | |
| WO | 2015133321 | A1 | 11 September 2015 | JP | 2015170911 | A | 28 September 2015 |

Form PCT/ISA/210 (patent family annex) (July 2022)